(19) Europäisches Patentamt
European Patent Office
Office européen des brevets

(11) EP 1 791 165 A1

(12) EUROPEAN PATENT APPLICATION
published in accordance with Art. 158(3) EPC

(43) Date of publication:
30.05.2007 Bulletin 2007/22

(51) Int Cl.:
H01L 21/027 (2006.01)    G01B 11/00 (2006.01)
G03F 7/20 (2006.01)    H01L 21/68 (2006.01)

(21) Application number: 05768639.6

(22) Date of filing: 02.08.2005

(86) International application number:
PCT/JP2005/014115

(87) International publication number:
WO 2006/013856 (09.02.2006 Gazette 2006/06)

(84) Designated Contracting States:
AT BE BG CH CY CZ DE DK EE ES FI FR GB GR
HU IE IS IT LI LT LU LV MC NL PL PT RO SE SI
SK TR

(30) Priority: 05.08.2004   JP 2004229005
18.04.2005   JP 2005120187

(71) Applicant: NIKON CORPORATION
Tokyo 100-8831 (JP)

(72) Inventors:
• SHIBAZAKI, Yuichi,
c/o NIKON CORPORATION
Tokyo 100-8331 (JP)

• OKUMURA, Masahiko,
c/o NIKON CORPORATION
Tokyo 100-8331 (JP)
• HIDAKA, Yasuhiro,
c/o NIKON CORPORATION
Tokyo 100-8331 (JP)

(74) Representative: HOFFMANN EITLE
Patent- und Rechtsanwälte
Arabellastrasse 4
81925 München (DE)

(54) STAGE DEVICE AND EXPOSURE SYSTEM

(57) The position of a movable stage is detected without increasing cost or the size of apparatus. An apparatus comprises movable stages (WST, MST) that move along a plane of motion (12a); and a position-detection apparatus that detects the positions of the movable stages (WST, MST) with beams (B1 to B3). The apparatus further comprises driving apparatuses (82, 84) that drives the movable stages (WST, MST); follow-up optical members (30 to 33) which are provided on the driving apparatuses (81, 84) and cause the beams (B1 to B3) to follow the movable stages (WST, MST) as the movable stages (WST, MST) move; and first optical members (34 to 39) which are provided on the movable stages (WST, MST) and are optically coupled with the follow-up optical members (30 to 33).

FIG. 3

**Description**

TECHNICAL FIELD

The present invention relates to stage apparatuses and exposure apparatuses and relates to, for example, a stage apparatus and an exposure apparatus for detecting the position of a movable stage using a beam such as a laser beam.

This application claims priority on Japanese Patent Application Nos. 2004-229005, filed on August 5, 2004 and 2005-120187, filed on April 18, 2005.

BACKGROUND ART

Stage apparatuses having movable stages employ interferometers for detecting a position in a direction along a plane of motion (e.g., X-axial direction, Y-axial direction) by providing reflecting surfaces on the movable stages (or on movable mirrors mounted on the movable stages) and receiving the reflection of beams, such as laser beams, emitted to these reflecting surfaces. Furthermore, Patent Document 1 disclosed an interferometer which is constructed so as to detect a position in the Z direction (height position) of a movable stage by changing the direction of a beam emitted in a direction along a plane of motion towards a direction orthogonal to the plane of motion (Z direction) on the movable stage to cause the beam to be reflected at a reflecting plate provided above the movable stage.

[Patent Document 1] Published Japanese Translation No. 2001-510577 of the PCT International Publication

DISCLOSURE OF INVENTION

PROBLEMS TO BE SOLVED BY THE INVENTION

However, the above-described technique is associated with the following problems.

With a larger stroke of the movable stage, the movable mirror mounted on the movable stage also needs to be larger. This leads to an increase in the weight of the stage and, consequently, adversely affects the movement performance of the stage. Furthermore, while the temperature of the optical path of a beam is adjusted by downflow to prevent the detection accuracy from decreasing due to heat generated by the beam, a structure, such as the one associated with the technique disclosed in Patent Document 1, where the reflecting plate is provided above the movable stage to detect the height position of the movable stage makes it difficult to secure a location for installing downflow equipment. In addition, since a projection optical system and measuring instruments used to measure the position of a wafer are disposed above the movable stage, the size of the apparatus may need to be increased to lay out these instruments such that they do not interfere with the reflecting plate.

**[0007]** - Furthermore, when the stage moves a long stroke, such as when the stage moves to a wafer exchange position beyond an exposure area, the stage is out of the position-detectable range of the interferometer. If this is the case, a so-called interferometer changeover, where another interferometer is used to continue position detection of the stage, is required. This leads to an increase in cost and a decrease in throughput resulting from an increased number of interferometer axes. In particular, in a stage apparatus having a plurality of movable stages, the number of interferometer axes needs to be increased to continue position detection on both movable stages, which may lead to a significant increase in cost. Furthermore, if a plurality of movable stages is provided, a beam irradiator (light source) and a photoreceiver need to be provided for each stage, which may also lead to an increase in the cost and the size of the apparatus.

The present invention has been conceived in light of the above-described circumstances, and an object thereof is to provide a stage apparatus and an exposure apparatus that can perform position detection of a movable stage without increasing the cost or size of these apparatuses.

MEANS FOR SOLVING THE PROBLEM

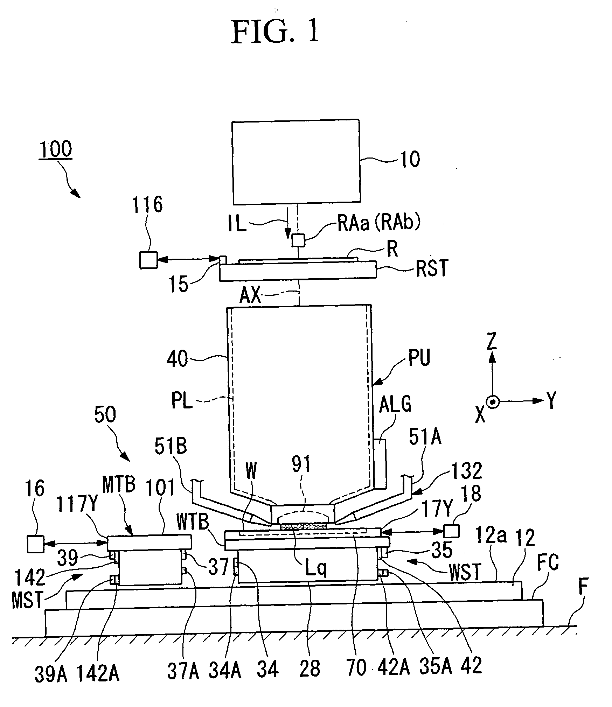

To achieve the above-described object, the present invention employs the following structures associated with FIGs. 1 to 25, which show embodiments.

A stage apparatus according to the present invention is a stage apparatus (50) including: movable stages (WST, MST) moving along a plane of motion (12a); and a position-detection apparatus (118) for detecting the positions of the movable stages (WST, MST) with beams (B1 to B3). The stage apparatus (50) further includes driving apparatuses (82, 84) for driving the movable stages (WST, MST); follow-up optical members (32, 33 and 30, 31) which are provided on the driving apparatuses (82 and 84) and cause the beams (B1 to B3) to follow the movable stages (WST and MST) as the movable stages (WST, MST) move; and first optical members (34 to 36 and 37 to 39) which are provided on the movable stages (WST, MST) and are optically coupled with the follow-up optical members (32, 33 and 30, 31).

Therefore, in the stage apparatus according to the present invention, the positions of the movable stages (WST, MST) can be detected by emitting a beam to the first optical members (34 to 36 and 37 to 39) via the follow-up optical members (32, 33 and 30, 31). Since these follow-up optical members (34 to 36 and 37 to 39) are provided on the driving apparatuses (82, 84), the beams (B1 to B3) follow the movable stages (WST, MST) even when the movable stages (WST, MST) move through driving by the driving apparatuses (82, 84). For this reason, it is not necessary to provide the movable stages (WST, MST) with a movable mirror of length according to the movement stroke, as in the case where the beam is fixed. Not only can this prevent the movable stages (WST, MST) from becoming heavy, but also this can eliminate the need of interferometer changeover. As a result, an increase in cost and a decrease in throughput resulting from an increase in the number of interferometer axes can be prevented.

Furthermore, a stage apparatus according to the present invention is a stage apparatus (50) including movable stages (WST, MST) moving along a plane of motion (12a) and a position-detection apparatus (118) for detecting the positions of the movable stages (WST, MST). This stage apparatus (50) further includes first optical members (34 to 39) provided on the movable stages (WST, MST); second optical members (30 to 33) for changing the direction of beams (B1 to B3) from light sources (55a to 55c) towards the first optical members (34 to 39); and follow-up apparatuses (82, 84) for causing the second optical members (30 to 33) to follow the movement of the movable stages (WST, MST).

Therefore, in-the stage apparatus according to the present invention, the positions of the movable stages (WST, MST) can be detected by changing the direction of the beams (B1 to B3) from the light sources (55a to 55c) by the second optical members (30 to 33) and emitting the beams (B1 to B3) to the first optical members (34 to 39). Since these second optical members (30 to 33) follow the movable stages (WST, MST) even when the movable stages (WST, MST) move, the beams towards the first optical members (34 to 39) also follow. For this reason, it is not necessary to provide the movable stages (WST, MST) with a movable mirror of length according to the movement stroke, as in the case where the beam is fixed. Not only can this prevent the movable stages (WST, MST) from becoming heavy, but also this can eliminate the need of interferometer changeover. As a result, an increase in cost and a decrease in throughput resulting from an increase in the number of interferometer axes can be prevented.

A stage apparatus according to the present invention is a stage apparatus (50) including movable stages (WST, MST) moving along a plane of motion (12a) and a position-detection apparatus (118) for detecting the positions of the movable stages (WST, MST). This stage apparatus (50) further includes first optical members (34 to 39) which are provided on the movable stages (WST, MST) and change the direction of incident beams (BT1, BT3, BR1, BR3) towards a direction intersecting the plane of motion (12a) and second optical parts (34A, 35A, 37A, 39A) which are provided on the movable stages (WST, MST) and change the direction of beams (BT12, BT32, BR12, BR32) from the first optical members (34 to 39) towards a direction intersecting the plane of motion (12a).

Therefore, in the stage apparatus according to the present invention, if the positions of the movable stages (WST, MST) in a direction intersecting the plane of motion (12a) are to be detected by changing the direction of the incident beams (BT1, BT3, BR1, BR3) and emitting the incident beams towards that direction using the first optical members (34 to 39) and the beams (BT12, BT32, BR12, BR32) emitted from these first optical members (34 to 39) are blocked by, for example, the movable stages (WST, MST), this detection of the positions of the movable stages (WST, MST) in the direction intersecting the plane of motion (12a) can be performed by changing the direction of the beams towards the second optical parts (34A, 35A, 37A, 39A) using the first optical members (34, 35, 37, 39) and then changing the direction of the beams and emitting the beams towards the direction intersecting the plane of motion (12a) using these second optical parts (34A, 35A, 37A, 39A).

Furthermore, a stage apparatus according to the present invention is a stage apparatus (50) including movable stages (WST, MST) moving along a plane of motion (12a) and a position-detection apparatus (118) for detecting the positions of the movable stages (WST, MST) with beams (B 1 to B3). This stage apparatus (50) further includes optical separation members (34 to 39) which are provided on the movable stages (WST, MST) and which divide the beams (B1 to B3) into first measuring beams (BR11, BR21, BR31, BT11, BT21, BT31) along the plane of motion (12a) and second measuring beams (BR12, BR22, BR32, BT12, BT22, BT32) intersecting the plane of motion (12a) and a reflecting member (27) composed of a first reflecting surface (27a) reflecting the first measuring beams (BR11, BR21, BR31, BT11, BT21, BT31) towards the optical separation members (34 to 39) and a second reflecting surface (27b) reflecting the second measuring beams (BR12, BR22, BR32, BT12, BT22, BT32) towards the optical separation members (34 to 39).

Therefore, in the stage apparatus according to the present invention, with the first measuring beams (BR11, BR21, BR31, BT11, BT21, BT31) that have been incident upon the optical separation members (34 to 39) after being reflected at the first reflecting surface (27a) set as reference beams, the positions of the movable stages (WST, MST) in a direction intersecting the plane of motion (12a) can be detected by using the second measuring beams (BR12, BR22, BR32, BT12, BT22, BT32) that have been incident upon the optical separation member (34 to 39) after being reflected at the second reflecting surface (27b). Since the first measuring beam (BR11, BR21, BR31, BT11, BT21, BT31) and the second measuring beam (BR12, BR22, BR32, BT12, BT22, BT32) are generated by dividing one beam, an increase in cost and size of the apparatus, which would result if light sources were provided individually, can be prevented.

A stage apparatus according to the present invention is a stage apparatus (50) including a first movable stage (WST) moving along a plane of motion (12a); a second movable stage (MST) moving along the plane of motion (12a); and a position-detection apparatus (118) for detecting the positions of the first movable stage (WST) and the second movable stage (MST) with beams (B1 to B3). This stage apparatus (50) further includes optical separation systems (30, 31) for dividing the beams (B1 to B3) into first beams (BT1 to BT3) and second beams (BR1 to BR3) such that the height positions in a direction orthogonal to the plane of motion (12a) are the same; first optical systems (34 to 36) which are provided on the first movable stage (WST) and change the height positions of the incident first beams (BT1 to BT3) and emit the first beams; and second optical systems (37 to 39) which are provided on the second movable stage (MST) and change the height positions of the incident second beams (BR1 to BR3) and emit the second beams.

Therefore, in the stage apparatus according to the present invention, the position of the first movable stage (WST) can be detected with the first beams (BT1 to BT3), and the position of the second movable stage (MST) can be detected with the second beams (BR1 to BR3). Since the first beams (BT1 to BT3) and the second beam (BR1 to BR3) are generated by dividing one beam, an increase in cost and size of the apparatus, which would result if light sources were provided individually, can be prevented. Furthermore, since the height positions of the first and the second beams are changed by the first and the second optical systems (34 to 36 and 37 to 39), respectively, when they are emitted, a plurality of light receiving parts (pickups) can individually detect the positions of the first and the second movable stages (WST, MST) by varying the height positions between the first and the second beams that are to be emitted.

Furthermore, a stage apparatus according to the present invention is a stage apparatus (50) including a first movable stage (WST) moving along a plane of motion (12a); a second movable stage (MST) moving along the plane of motion (12a); and a position-detection apparatus (118) for detecting the positions of the first movable stage (WST) and the second movable stage (MST). This stage apparatus (50) further includes first optical systems (34 to 36) provided on the first movable stage (WST); second optical systems (37 to 39) provided on the second movable stage (MST); and a reflecting member (27) reflecting first beams (BT1 to BT3) from the first optical system (34 to 36) and second beams (BR1 to BR3) from the second optical system (37 to 39).

Therefore, in the stage apparatus according to the present invention, the position of the first movable stage (WST) can be detected by the first beams (BT1 to BT3) from the first optical systems (34 to 36) reflected at the reflecting member (27), and the position of the second movable stage (MST) can be detected by the second beams (BR1 to BR3) reflected at the reflecting member (27). Since this reflecting member (27) reflects both the first beams and the second beams, an increase in cost and size of the apparatus, which would result if a reflecting member were provided for each beam, can be prevented.

An exposure apparatus according to the present invention is an exposure apparatus (100) which exposes a pattern onto a substrate (W) using the stage apparatus (50) and is characterized by employing the above-described stage apparatus (50) as a stage apparatus.

Therefore, in the exposure apparatus according to the present invention, the position of the substrate (W) can be detected via the movable stage (WST) without increasing the cost or the size of the apparatus.

Furthermore, an exposure apparatus according to the present invention is an exposure apparatus for exposing a pattern onto a substrate (W) via liquid supplied to the substrate (W). This exposure apparatus includes a first substrate table (WTB) having a support surface for supporting the substrate (W); a first stage main body (28) which is provided below the first substrate table (WTB) and which has at least one side surface positioned towards an inner side from a side surface of the first substrate table (WTB); a first optical member (35) which is provided on the at least one side surface of the first stage main body (28) and which emits an incident beam in a direction intersecting the support surface; and a first position-detection apparatus (22) which detects a position of the substrate (W) in a direction intersecting the support surface in conjunction with the first optical member (35).

Although the present invention has been described with reference to symbols shown in drawings showing one embodiment for a better understanding thereof, the present invention is not limited to this embodiment.

EFFECTS OF THE INVENTION

According to the present invention, a beam can be made to follow the movement of the moving table without interrupting measurement. Furthermore, according to the present invention, the position of the movable stage can be detected with high accuracy with a simple structure.

BRIEF DESCRIPTION OF THE DRAWINGS

FIG. 1 is a schematic diagram of an exposure apparatus, showing an embodiment of the present invention.
FIG. 2 is a perspective view of a stage apparatus constituting an exposure apparatus.
FIG. 3 is a plan view of the same stage apparatus.

FIG. 4 is a front view of a Z-axis interferometer.

FIG. 5 is a diagram showing a prism and a fixed mirror provided on a wafer stage.

FIG. 6 is a diagram showing an optical path of a reflected beam.

FIG 7 is a diagram showing prisms and a fixed mirror provided on a wafer stage.

FIG. 8 is a diagram showing an optical path of a reflected beam.

FIG. 9 is a diagram showing a prism and a fixed mirror provided on a measurement stage.

FIG 10 is a diagram showing an optical path of a reflected beam.

FIG. 11 is a diagram showing prisms and a fixed mirror provided on a measurement stage.

FIG. 12 is a diagram showing an optical path of a reflected beam.

FIG. 13 is a block diagram showing major components of a control system of an exposure apparatus.

FIG 14 is a diagram showing the relationship between prisms and their measurement points on a wafer stage.

FIG. 15A is a view from arrow A in FIG 14, illustrating the process of obtaining a Z displacement at an arbitrary position.

FIG. 15B is a view from arrow B in FIG. 14, illustrating the process of obtaining a Z displacement at an arbitrary position.

FIG 16 is a diagram showing the relationship between prisms and their measurement points on a measurement stage.

FIG. 17A is a plan view for illustrating parallel processing in an embodiment.

FIG. 17B is a plan view for illustrating parallel processing in an embodiment.

FIG. 18A is a plan view for illustrating parallel processing in an embodiment.

FIG. 18B is a plan view for illustrating parallel processing in an embodiment.

FIG 19 is a plan view for illustrating parallel processing in an embodiment.

FIG. 20 is a partial plan view in schematic form showing the structure of a stage apparatus according to a second embodiment.

FIG 21 is a diagram showing optical element groups and a fixed mirror provided on a wafer stage.

FIG 22 is a diagram showing an optical element group and a fixed mirror provided on a wafer stage.

FIG. 23 is a plan view of a third embodiment of a stage apparatus.

FIG. 24 is a partial front view of a wafer stage according to the third embodiment.

FIG. 25 is a flowchart illustrating one example of the process of manufacturing a semiconductor device.

DESCRIPTION OF THE REFERENCE SYMBOLS

B1 to B3: detecting beam (beam), BR1, BR2, BR3: reflected beam (second beam), BT1, BT2, BT3: transmission beam (reflected beam, first beam), BR11, BR21, BR31, BT11, BT21, BT31: measuring beam (first measuring beam), BR12, BR22, BR32, BT12, BT22, BT32: measuring beam (second measuring beam), R: reticle (mask), MST: measurement stage (movable stage, second movable stage), MTB: measurement table (second substrate table), W: wafer (substrate), WST: wafer stage (movable stage, first movable stage), WTB: wafer table (first substrate table), 8, 9: temperature regulator, 12a: upper surface (plane of motion), 22: Z-axis interferometer (first position-detection apparatus, second position-detection apparatus), 20: main control apparatus (correction apparatus, control apparatus), 27: fixed mirror (reflecting member), 27a: reflecting surface (first reflecting surface), 27b: reflecting surface (second reflecting surface), 28: wafer stage main body (first stage main body), 30, 31: half mirror (follow-up optical member, second optical member, optical separation system), 32, 33: bending mirror for changing the direction of the beam (follow-up optical member, second optical member), 34 to 36, 36A to 36D: prism (first optical member, first optical system, optical separation member), 34A, 35A, 37A, 39A: prism (second optical part), 37 to 39: prism (first optical member, second optical system, optical separation member), 50: stage apparatus, 52: measurement stage main body (second stage main body), 54: magnet unit (second mover), 55a, 55b, 55c: light sending part (light source), 82, 84: Y-axis linear motor (driving apparatus, follow-up apparatus), 80: stator (first stator), 81: stator (second stator), 90: magnet unit (first mover), 100: exposure apparatus, 118: interferometer system (position-detection apparatus), 151, 171: bending mirror for changing the direction of the beam (first optical system), 152: beam splitter (optical separation member). 154, 163: prism (second optical part), 161: beam splitter (first optical member, optical separation member)

BEST MODE FOR CARRYING OUT THE INVENTION

Embodiments of a stage apparatus and an exposure apparatus according to the present invention will now be described with reference to FIGs. 1 through 19.

Here, a stage apparatus according to the present invention is described by way of example of a wafer stage.

FIG. 1 is a schematic representation of the structure of an exposure apparatus 100 according to this embodiment.

The exposure apparatus 100 is a step-and-scan type projection exposure apparatus, i.e., a so-called scanning stepper. The exposure apparatus 100 comprises: an illumination system 10; a reticle stage RST that holds a reticle (mask) R, which serves as a mask; a projection unit PU; a stage apparatus 50, which comprises a wafer stage WST serving as a first movable stage (movable stage) and a measurement stage MST serving as a second movable stage (movable stage); and a control system therefore. A wafer W serving as a substrate is mounted on the wafer stage WST.

The illumination system 10 illuminates a slit-shaped illumination area on the reticle R, which is defined by a reticle blind (not shown), with illumination light (exposure light) IL, which serves as an energy beam, that has a substantially uniform illuminance. Here, as one example, ArF excimer laser light (193 nm wavelength) is used as the illumination light IL.

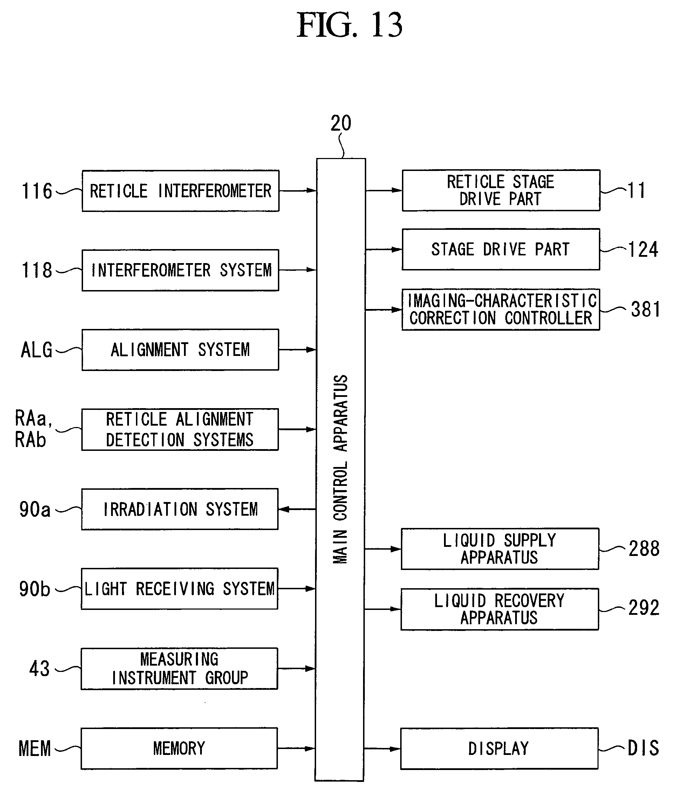

The reticle R, which has a surface (the lower surface in FIG 1) wherein a pattern, such as a circuit pattern, is formed, is fixed to the reticle stage RST by, for example, vacuum chucking. The reticle stage RST is capable of fine movement within an XY plane, which is orthogonal to the optical axis of the illumination system 10 (aligned with an optical axis AX of a projection optical system PL, which is discussed later), by a reticle stage drive part 11 (not shown in FIG. 1, but refer to FIG 13), which includes, for example, a linear motor, and is capable of moving at a specified scanning speed in a prescribed scanning direction (here, the Y-axial direction, which is the lateral direction, within the paper surface in FIG 1).

The position (including the rotational position about the Z axis) of the reticle stage RST within a plane of motion of the stage is continuously detected by a reticle laser interferometer (hereinafter, generically referred to as a reticle interferometer) 116, which has a resolving power of, for example, approximately 0.5 to 1 nm, via a movable mirror 15 (actually, a Y movable mirror that has a reflecting surface orthogonal to the Y-axial direction and an X movable mirror that has a reflecting surface orthogonal to the X-axial direction are provided). A measurement value of the reticle interferometer 116 is sent to a main control apparatus 20 (not shown in FIG. 1, but refer to FIG. 13). The main control apparatus 20 calculates the position of the reticle stage RST in the X-axial direction, the Y-axial direction, and the θZ direction (the rotational direction about the Z axis) based on the measurement value of the reticle interferometer 116, and controls the position (and the velocity) of the reticle stage RST by controlling the reticle stage drive part 11 based on the calculation results.

A pair of reticle alignment detection systems RAa and RAb is provided above the reticle R spaced apart in the X-axial direction by a prescribed distance, and comprises a TTR (Through the Reticle) alignment system that uses light of exposure wavelength to simultaneously observe a pair of reticle alignment marks, which are on the reticle R, as well as a pair of fiducial marks (hereinafter, referred to as the first reference marks), which are on the measurement stage MST and correspond to the pair of reticle alignment marks, through the projection optical system PL. A system constituted the same as the one disclosed in, for example, Japanese Unexamined Patent Application, First Publication No. H7-176468 (corresponding U.S. Patent No. 5,646,413) is used as the reticle alignment detection systems RAa and RAb.

The projection unit PU includes a lens barrel 40 and the projection optical system PL, which comprises a plurality of optical elements that are held in the lens barrel 40 with a prescribed positional relationship. A dioptric system comprising a plurality of lenses (lens elements) that share the optical axis AX in, for example, the Z-axial direction is used as the projection optical system PL.

Furthermore, although not shown in the figure, particular lenses of the plurality of lenses constituting the projection optical system PL are controlled by an imaging-characteristic correction controller 381 (refer to FIG. 13) based on a command from the main control apparatus 20 so that optical characteristics (including imaging characteristics) of the projection optical system PL, such as the magnification, the distortion, the coma aberration, and the field curvature (including the field tilting), can be adjusted.

In addition, the exposure apparatus 100 of the present embodiment performs exposure that is adapted to a liquid immersion method, and consequently, a liquid supply nozzle 51A and a liquid recovery nozzle 51B, which constitute an immersion apparatus 132, are provided in the vicinity of a lens (hereinafter, also referred to as a front lens) 91, which is the optical element that is most adjacent to the image plane side (wafer W side) from among the optical elements that constitute the projection optical system PL.

A supply pipe (not shown in the figure), which has one end thereof connected to a liquid supply apparatus 288 (not shown in FIG. 1, but refer to FIG 13), has the other end thereof connected to the above-described liquid supply nozzle 51A. A recovery pipe (not shown in the figure), which has one end thereof connected to a liquid recovery apparatus 292 (not shown in FIG 1, but refer to FIG. 13), has the other end thereof connected to the above-described liquid recovery nozzle 51B.

Here, ultrapure water (hereinafter, simply noted as "water" except in cases where it is particularly necessary), which transmits ArF excimer laser light (light of a 193 nm wavelength), is used as the above-mentioned liquid. Ultrapure water has advantages in that it can be easily obtained in large quantity at semiconductor manufacturing plants, etc. and in that it has no adverse effects on the photoresist on the wafer or optical lenses.

The index of refraction n of water is about 1.44. In this water, the wavelength of the illumination light IL is shortened to 193 nm $\times$ 1/n = about 134 nm.

According to a command from the main control apparatus 20, the liquid supply apparatus 288 opens the valve connected to the supply pipe to a predetermined valve travel so that water is supplied to between the front lens 91 and the wafer W via the liquid supply nozzle 51 A. Furthermore, at this time, according to a command from the main control apparatus 20, the liquid recovery apparatus 292 opens the valve connected to the recovery pipe to a predetermined valve travel so that water is collected into the liquid recovery apparatus 292 (liquid tank) from between the front lens 91 and the wafer W via the liquid recovery nozzle 51B. At this time, the main control apparatus 20 issues a command to the liquid supply apparatus 288 and the liquid recovery apparatus 292 so that the amount of water supplied to between the front lens 91 and the wafer W via the liquid supply nozzle 51 A is always equal to the amount of water collected via the liquid recovery nozzle 51B. Therefore, a certain amount of water Lq (refer to FIG. 1) is held between the front lens 91 and the wafer W. In this case, the water Lq held between the front lens 91 and the wafer W is continuously replaced.

As is apparent from the above-described description, the immersion apparatus 132 according to this embodiment is a local liquid immersion apparatus that includes the above-described liquid supply apparatus 288, liquid recovery apparatus 292, supply pipe, recovery pipe, liquid supply nozzle 51A, liquid recovery nozzle 51B, and so forth.

When the measurement stage MST-is positioned below the projection unit PU, water can also be held between the measurement table MTB and the front lens 91 in the same manner as described above.

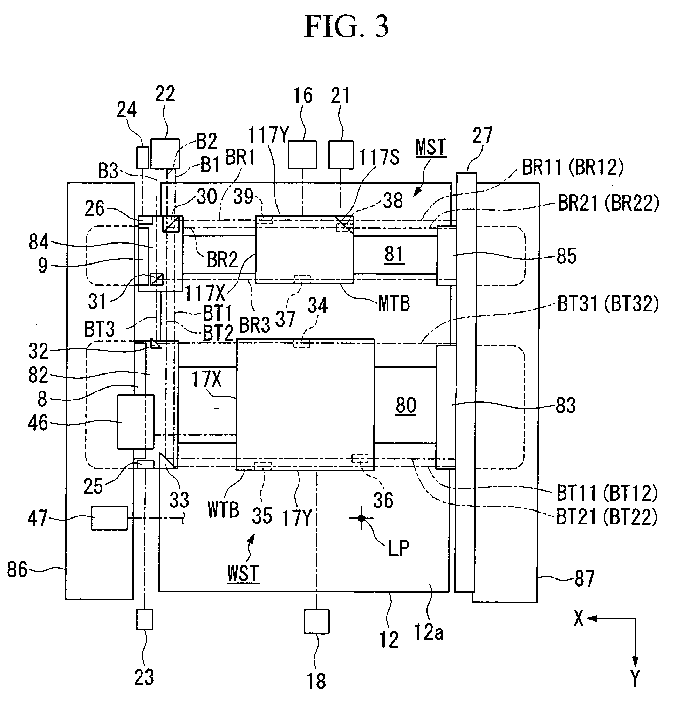

The stage apparatus 50 comprises: a frame caster FC; a base plate 12, which is provided on the frame caster FC; the wafer stage WST and the measurement stage MST, which are disposed above the base plate 12 and move along an upper surface (plane of motion) 12a thereof; an interferometer system 118 (refer to FIG 13) serving as a position-detection apparatus, which includes interferometers 16 and 18 that detect the positions of the stages WST and MST; a stage drive part 124 (refer to FIG. 13) that drives the stages WST and MST; and temperature regulators 8 and 9 (refer to FIG. 3).

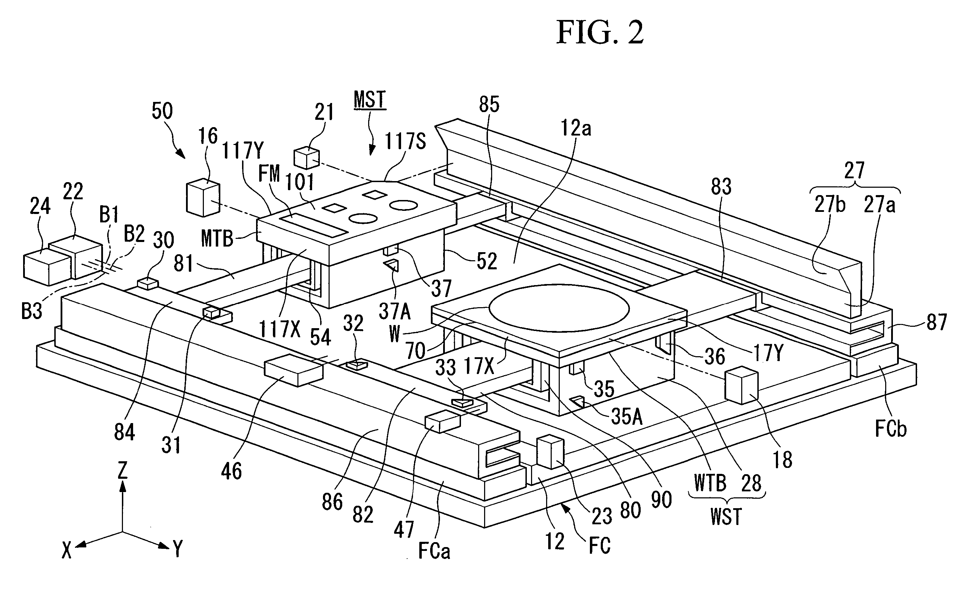

As shown in FIG. 2, the substantially plate shaped frame caster FC comprises upwardly protruding parts FCa and FCb, which are integrally formed in the vicinity of both end parts of the frame caster FC in the X-axial direction, that are oriented so that the longitudinal direction is in the Y-axial direction.

The base plate 12 is disposed above the area that is interposed between the protruding parts FCa and FCb of the frame caster FC. The upper surface 12a of the base plate 12 is finished with an extremely high degree of flatness and forms a guide surface when the wafer stage WST and the measurement stage MST move along the XY plane.

As shown in FIG. 2, the wafer stage WST comprises a wafer stage main body 28, which is disposed on the base plate 12, and a wafer table WTB, which is mounted via a Z tilt drive mechanism (not shown) on the wafer stage main body 28. Actually, the Z tilt drive mechanism comprises three actuators (e.g., voice coil motors and EI cores) that support the wafer table WTB on the wafer stage main body 28 at three points. The Z tilt drive mechanism finely drives the wafer table WTB in the directions of the three degrees of freedom, i.e., the Z-axial direction, the θx direction (rotational direction about the-X axis), and the θy direction (rotational direction about the Y axis), by adjusting the driving of each of the actuators.

The wafer stage main body 28 comprises a hollow member, which is rectangularly frame-shaped in its cross section and extends in the X-axial direction. A self weight canceling mechanism, such as the one recited in Japanese Patent Application No. 2004-215439 previously filed by the present applicant, is provided to the lower surface of the wafer stage main body 28. The self weight canceling mechanism comprises: a support part, which supports the wafer stage WST by applying internal pressure to a bellows; and an air bearing part that opposes the guide surface 12a and levitates the wafer stage WST off the guide surface 12a.

Stators 86 and 87, which are for the Y axis and extend in the Y-axial direction, are provided and disposed above the protruding parts FCa and FCb of the frame caster FC, as shown in FIG. 2. These Y-axis stators 86 and 87 are levitationally supported with a prescribed clearance from the upper surfaces of the respective protruding parts FCa and FCb by aerostatic bearings (not shown), e.g., air bearings, which are provided to the lower surface of each of the stators 86 and 87. This is because the reaction force generated by the movement of the wafer stage WST or the measurement stage MST in the Y direction moves the stators 86 and 87 in the reverse direction as countermasses, and this reaction force is offset in accordance with the law of conservation of momentum. In the present embodiment, the Y-axis stators 86 and 87 each comprise a magnetic pole unit, which is composed of a plurality of permanent magnet groups.

The above-described hollow member (aperture) is formed in the wafer stage main body 28, and a magnetic pole unit 90, which comprises permanent magnet groups that serve as a mover in the X-axial direction, is provided inside this hollow member (aperture). An X-axis stator 80, which extends imthe-X-axial direction, is inserted in an internal space of the magnet unit 90. This X-axis stator 80 comprises an armature unit, wherein a plurality of armature coils are built in and disposed at prescribed intervals along the X-axial direction. In this case, the magnetic pole unit 90 and the X-axis stator 80, which comprises the armature unit, constitute a moving magnet type X-axis linear motor that drives the wafer stage WST in the X-axial direction, which is a first direction.

The above-mentioned X-axis linear motor shall generically be called the X-axis linear motor 80 and will use the same symbol as the stator (X-axis stator) 80. Furthermore, a moving coil type linear motor may be used as the X-axis linear motor 80 in place of the moving magnet type linear motor.

Sliders 82 and 83, which each comprise an armature unit wherein, for example, a plurality of armature coils are built in and disposed at prescribed intervals along the Y-axial direction, are fixed to the end parts on both sides of the X-axis stator 80 in the longitudinal direction, one on each side. These movers 82 and 83 are inserted in the respective Y-axis stators 86 and 87, which were discussed above, from the inner sides. Namely, in the present embodiment, the movers 82 and 83, which each comprise an electric unit, and the Y-axis stators 86 and 87, which each comprise a magnetic pole unit, constitute a moving coil type Y-axis linear motor that drives the wafer stage WST in the Y-axial direction, which is a second direction.

Hereinbelow, the above-mentioned two Y-axis linear motors are generically referred to as the Y-axis linear motors (driving apparatuses, follow-up apparatuses) 82 and 83, and use the same symbols as the movers 82 and 83. Furthermore, moving magnet type linear motors may be used as the Y-axis linear motors 82 and 83 in place of the moving coil type linear motors.

The wafer stage WST is driven in the X-axial direction by the X-axis linear motor 80 and in the Y-axial direction by the pair of Y-axis linear motors 82 and 83 integrally with the X-axis linear motor 80. In addition, the wafer stage WST is rotationally driven in the $\theta z$ direction by slightly varying the driving force generated by the Y-axis linear motors 82 and 83 in the Y-axial direction. Accordingly, the wafer table WTB can be finely driven without contact in each direction (X, Y, Z, $\theta x$, $\theta y$, $\theta z$) of the six degrees of freedom by driving the three actuators, which support the wafer table WTB, the X-axis linear motor 80, and the Y-axis linear motors 82 and 83.

A wafer holder 70 supporting the wafer W is provided on the above-described wafer table WTB. The wafer holder 70 comprises a plate-shaped main body part and a liquid-repellent (water-repellent) auxiliary plate, wherein a circular aperture whose diameter is larger than that of the wafer W is formed at its center, that is fixed to the upper surface of the main body part. Numerous (plural) pins are disposed in an area of the main body part inside the circular aperture of the auxiliary plate. The numerous pins vacuum-chuck the wafer W in a supported state. In this state, wherein the wafer W is vacuum chucked, the height of the front surface of the wafer W and the front surface of the auxiliary plate are substantially the same. Furthermore, liquid repellency may be imparted to the front surface of the wafer table WTB without providing the auxiliary plate.

In addition, as shown in FIG. 2, a reflecting surface 17X, which is orthogonal to the X-axial direction (i.e., extends in the Y-axial direction) is formed by mirror surface processing at one end (+X side end) of the wafer table WTB in the X-axial direction. Likewise, a reflecting surface 17Y, which is orthogonal to the Y-axial direction (i.e., extends in the X-axial direction) is formed by mirror surface processing at one end (+Y side end) of the wafer table WTB in the Y-axial direction. Interferometer beams (beams) from X-axis interferometers 46 and 47 and the Y-axis interferometer 18, which constitute the interferometer system 118 (refer to FIG. 13) discussed later, are projected to the reflecting surfaces 17X and 17Y. The interferometers 46, 47, and 18 receive reflected beams and thereby detect the displacement in the measurement direction from a reference position of each of the reflecting surfaces 17X and 17Y (generally, a fixed mirror is disposed on a side surface of the projection unit PU and a side surface of an off-axis alignment system ALG-refer to FIGs. 1 and 13-and such is used as a reference surface).

Instead of forming the reflecting surfaces 17X and 17Y on end faces of the wafer table WTB, a Y movable mirror having a reflecting surface extending in the X-axial direction and an X movable mirror having a reflecting surface extending in the Y-axial direction may be provided individually on the upper surface of the wafer table WTB.

Position measurement using these interferometers 46, 47, and 18 will be described later.

Referring to FIG. 2, as with the wafer stage WST, the above-described measurement stage MST includes a measurement stage main body 52 disposed on the base plate 12 and a measurement table MTB mounted on the measurement main body 52 via a Z tilt drive mechanism (not shown in the figure). The Z tilt drive mechanism comprises three actuators (e.g., voice coil motors and EI cores) that support the measurement table MTB on the measurement stage main body 52 at three points, and finely drives the measurement table MTB in the directions of the three degrees of freedom, i.e., the Z-axial direction, the $\theta x$ direction, and the $\theta y$ direction, by adjusting the driving of each of the actuators.

The measurement stage main body 52 comprises a hollow member, which is rectangularly frame-shaped in its cross section and extends in the X-axial direction. A plurality of (e.g., four) aerostatic bearings (not shown), e.g., air bearings, is provided to the lower surface of the measurement stage main body 52. The measurement stage MST is noncontactually and levitationally supported above the guide surface 12a via these air bearings with a clearance of approximately several microns.

The above-described hollow member (aperture) is formed in the measurement stage main body 52, and a magnetic pole unit 54, which comprises permanent magnet groups that serve as a mover in the X-axial direction, is provided inside this hollow member (aperture). An X-axis stator 81, which extends in the X-axial direction, is inserted in an internal space of the magnetic pole unit 54. This X-axis stator 81 comprises an armature unit, wherein a plurality of armature coils are built in and disposed at prescribed intervals along the X-axial direction. In this case, the magnetic pole unit 54 and the X-axis stator 81, which comprises the armature unit, constitute a moving magnet type X-axis linear motor that drives the measurement stage MST in the X-axial direction.

The above-mentioned X-axis linear motor shall henceforth generically be called the X-axis linear motor 81 and will use the same symbol as the stator (X-axis stator) 81.

Sliders 84 and 85, which each comprise an armature unit wherein, for example, a plurality of armature coils are built in and disposed at prescribed intervals along the Y-axial direction, are fixed to the end parts on both sides of the X-axis stator 81 in the longitudinal direction, one on each side. These movers 84 and 85 are inserted in the respective Y-axis stators 86 and 87, which were discussed above, from the inner sides. Namely, in the present embodiment, the movers 84 and 85, which each comprise an electric unit, and the Y-axis stators 86 and 87, which each comprise a magnetic pole unit, constitute a moving coil type Y-axis linear motor.

Hereinbelow, the above-mentioned two Y-axis linear motors are generically referred to as the Y-axis linear motors (driving apparatuses) 84 and 85, and use the same symbols as the movers 84 and 85.

Thus, the measurement stage MST is driven in the X-axial direction by the X-axis linear motor 81 and in the Y-axial direction by the pair of Y-axis linear motors 84 and 85 integrally with the X-axis linear motor 81. In addition, the measurement stage MST is rotationally driven in the θz direction by slightly varying the driving force generated by each of the Y-axis linear motors 84 and 85 in the Y-axial direction. Accordingly, the measurement table MTB can be finely driven without contact in each direction (X, Y, Z, θx, θy, θz) of the six degrees of freedom by driving the three actuators, which support the measurement table MTB, the X-axis linear motor 81, and the Y-axis linear motors 84 and 85.

As is apparent from the explanation so far, the stage drive part 124, which is shown in FIG. 13, in the present embodiment comprises a fine movement mechanism (not shown) that drives the Y-axis linear motors 82 to 85, the X-axis linear motors 80 and 81, and the wafer table WTB, as well as a drive mechanism (not shown) that drives the measurement table MTB. The main control apparatus 20 shown in FIG. 13 controls various drive mechanisms that constitute the stage drive part 124.

The measurement table MTB further comprises measuring instruments for performing various measurements related to exposure. In further detail, a plate 101 made of glass material, such as quartz glass, is provided on the upper surface of the measurement table MTB. The entire surface of the plate 100 is coated with chromium; furthermore, an area for the measuring instruments and a fiducial mark area FM, wherein a plurality of fiducial marks are formed as disclosed in, for example, Japanese Unexamined Patent Application, First Publication No. H5-21314 (corresponding U.S. Patent No. 5,243,195), are provided at a prescribed position.

Patterning is applied to the above-described area for the measuring instruments to form various aperture patterns for measurement. Examples of aperture patterns for measurement that are formed include an aperture pattern for aerial-image measurement (e.g., slit-shaped aperture pattern), a pinhole aperture pattern for illuminance-irregularity measurement, an aperture pattern for illuminance measurement, and an aperture pattern for wavefront-aberration measurement.

A light receiving system for receiving, via the aperture pattern for aerial-image measurement, exposure light emitted to the plate 101 via the projection optical system PL and water is provided in the measurement table MTB disposed below the aperture pattern for aerial-image measurement. This constitutes an aerial-image measurement instrument for measuring the light intensity of an aerial image (projected image) of a pattern projected by the projection optical system PL, disclosed in, for example, Japanese Unexamined Patent Application, First Publication No. 2002-14005 (corresponding U.S. Patent Publication No. 2002/0041377).

Furthermore, a light receiving system including a light receiving element is provided in the measurement table MTB disposed below the pinhole aperture pattern for illuminance-irregularity measurement. This constitutes an illuminance-irregularity measuring instrument having a pinhole-shaped light receiving part for receiving the illumination light IL on the image plane of the projection optical system PL, disclosed in, for example, Japanese Unexamined Patent Application, First Publication No. S57-117238 (corresponding U.S. Patent No. 4,465,368).

In addition, a light receiving system including a light receiving element is provided in the measurement table MTB disposed below the aperture pattern for illuminance measurement. This constitutes an illuminance monitor having a light receiving part of a prescribed area for receiving the illumination light IL via water on the image plane of the projection optical system PL, disclosed in, for example, Japanese Unexamined Patent Application, First Publication No. H11-16816 (corresponding U.S. Patent Publication No. 2002/0061469).

Furthermore, a light receiving system including, for example, a microlens array is provided in the measurement table MTB disposed below the aperture pattern for wavefront-aberration measurement. This constitutes the wavefront-aberration measuring instrument disclosed in, for example, PCT International Patent Publication No. WO 99/60361 (corresponding European Patent No. 1,079,223).

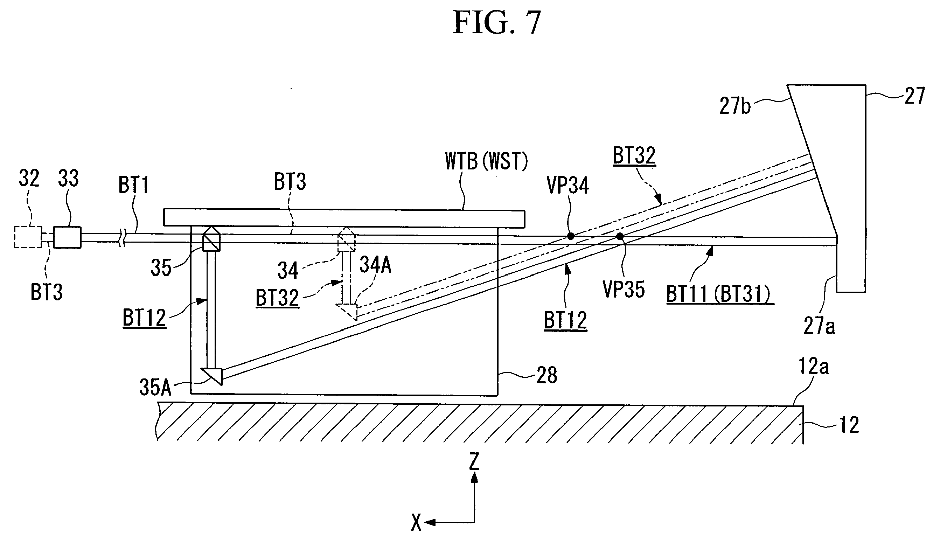

In FIG 7, the above-described aerial-image measurement instrument, illuminance-irregularity measuring instrument, illuminance monitor, and wavefront-aberration measuring instrument are denoted as a measuring instrument group 43.

In this embodiment, in accordance with immersion exposure where the wafer W is exposed to the exposure light (illumination light) IL via the projection optical system PL and water, the illumination light IL is received via the projection optical system PL and water in the above-described illuminance monitor, illuminance-irregularity measuring instrument, aerial-image measurement instrument, wavefront-aberration measuring instrument, and so forth used for measurement with the illumination light IL. For this reason, the surface of the plate 101 is processed with a water-repellent coating.

A reflecting surface 117Y that is orthogonal to the Y-axial direction (i.e., extends in the X-axial direction) is formed by mirror surface processing at one end (-Y side end) of the measurement table MTB (plate 101) in the Y-axial direction. In addition, a reflecting surface 117X that is orthogonal to the X-axial direction (i.e., extends in the Y-axial direction) is formed by mirror surface processing at one end (+X side end) of the measurement table MTB in the X-axial direction. Furthermore, a reflecting surface 117S for changing the direction of an interferometer beam along the Y-axial direction towards the X-axial direction is formed at one of the corners (-X side and -Y side in FIG. 2) of the measurement table MTB.

An interferometer beam (length-measuring beam) from the Y-axis interferometer 16, which constitutes the interferometer system 118, is projected to the reflecting surface 117Y, as shown in FIG 2. The interferometer 16 detects a displacement of the reflecting surface 117Y from the reference position by receiving the reflected beam.

Furthermore, an interferometer beam from the X-axis interferometer 46, which constitutes the interferometer system 118, is projected to the reflecting surface 117X, and the interferometer 46 detects a displacement of the reflecting surface 117X from the reference position by receiving the reflected beam. Furthermore, when the measurement table MTB moves to directly below the projection unit PU during, for example, measurement, an interferometer beam from the X-axis interferometer 46 is projected to the reflecting surface 117X, and the interferometer 46 measures a displacement of the reflecting surface 117X from the reference position by receiving the reflected beam.

Furthermore, an interferometer beam from an X-axis interferometer 21, which constitutes the interferometer system 118, is projected to the reflecting surface 117S, and the interferometer 21 detects a displacement of the reflecting surface 117X from the reference position by receiving the reflected beam.

Position measurement using these interferometers 16, 21, and 46 will be described later.

In addition to the above-described Y-axis interferometers 16 and 18 and the X-axis interferometers 21, 46, and 47, the interferometer system 118 (refer to FIG 13) includes a Z-axis interferometer 22; half mirrors 30 and 31 serving as follow-up optical members (second optical members) in the measurement stage MST; bending mirrors for changing the direction of the beam 32 and 33 serving as follow-up optical members (second optical members) in the wafer stage WST; three prisms 34 to 36 serving as first optical members provided on the wafer stage WST as shown in FIG. 3; three (a plurality of) prisms 37 to 39 serving as first optical members provided on the measurement stage MST; a fixed mirror (reflecting member) 27 provided above the stator 87 of the Y-axis linear motor; Y-axis interferometers 23 and 24; a movable mirror 25 provided on the mover 82 of the Y-axis linear motor; and a movable mirror 26 provided on the mover 84 of the Y-axis linear motor.

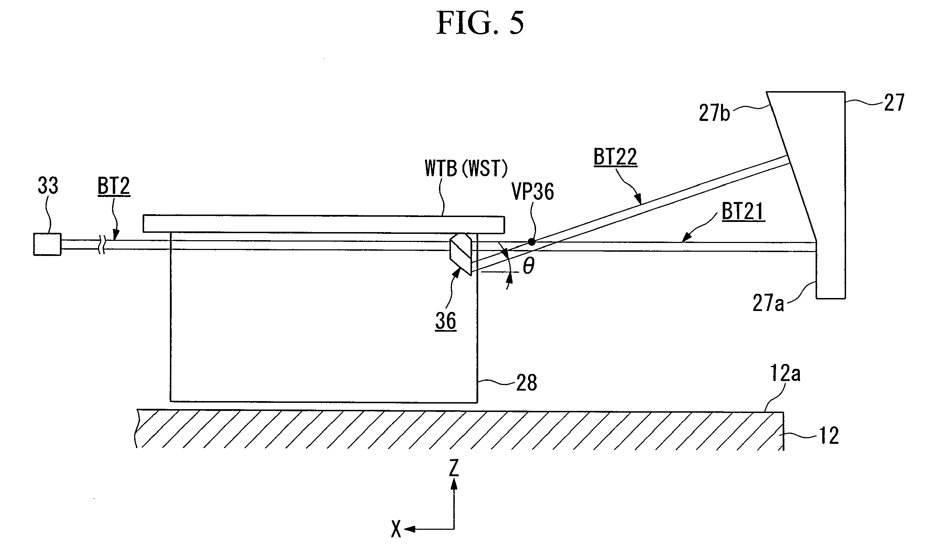

The fixed mirror 27 is provided along the Y-axial direction such that it is supported on the frame (not shown in the figure) supporting the projection unit PU. The fixed mirror 27 is integrally formed of a reflecting surface (first reflecting surface) 27a orthogonal to the Y axis (i.e., having an angle at which the reflecting surface 27a intersects the plane of motion 12a) and a reflecting surface (second reflecting surface) 27b having an angle that causes this reflecting surface 27b to intersect the reflecting surface 27a (a predetermined rotation angle about the Y axis in a direction facing the plane of motion 12a) (refer to FIG 5). These reflecting surfaces 27a and 27b will be described later in detail.

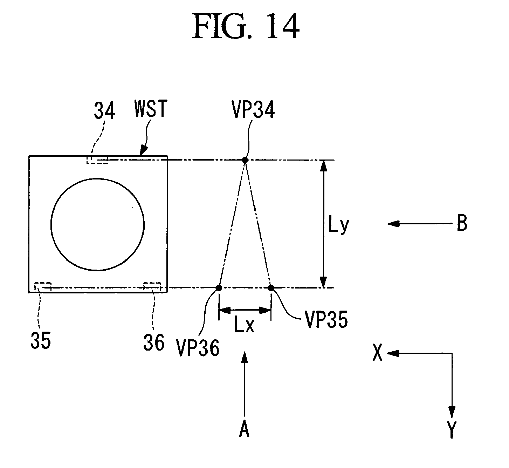

The Y-axis interferometer 18 has a length measuring axis that is parallel to the Y axis and that links the center of projection (optical axis AX; refer to FIG 1) of the projection optical system PL with the center of detection of the off-axis alignment system ALG to detect the position of the wafer table WTB in the Y-axial direction. The X-axis interferometer 46 is an interferometer that selects and measures the X position of the measurement table MTB and the X position of the wafer table WTB, and has a length measuring axis (length measuring axis at the projection center position in the Y-axial direction) that is parallel to the X axis and that orthogonally intersects the length measuring axis of the Y-axis interferometer 18 at the center of projection of the projection optical system PL (refer to FIG 14A). In addition, the X-axis interferometer 46 has a length measuring axis (length measuring axis at the alignment center position in the Y-axial direction) that is parallel to the X axis and that passes through the detection center of the alignment system ALG.

When performing the exposure operation, the X-axis interferometer 46 measures the position of the wafer table WTB in the X direction on the length measuring axis at the projection center position; furthermore, when performing enhanced global alignment (EGA), the X-axis interferometer 46 measures the position of the wafer table WTB in the X direction on the length measuring axis at the alignment center position. In addition, the X-axis interferometer 46 measures the position of the measurement table MTB in the X direction by appropriately using the two length measuring axes in accordance with the baseline measurement or what is to be measured with the measuring instrument group 43.

The X-axis interferometer 46 can measure the position of the wafer table WTB or the measurement table MTB in the X-axial direction at each of the projection center position and the alignment center position in the Y-axial direction.

The Y-axis interferometer 16 has a length measuring axis that is parallel to the Y axis and that orthogonally intersects the length measuring axis of the above-described X-axis interferometer 46 at the center of projection (optical axis AX) of the projection optical system PL.

The Y-axis interferometer 16 is a multi-axis interferometer having two optical axes and can measure an output value of each of the optical axes independently. As shown in FIG. 13, the output value (measurement value) of this Y-axis interferometer 16 is supplied to the main control apparatus 20, where the position in the Y-axial direction and the amount of Z yawing of the measurement table MTB can be measured based on the output value from the Y-axis interferometer 16. Furthermore, in the main control apparatus 20, the X position and the amount of rolling of the measurement table MTB are measured based on an output value from the X-axis interferometer 46.

The X-axis interferometer 21 has a length measuring axis that is parallel to the X-axial direction as a result of being changed the direction at the reflecting surface 117S of the measurement table MTB.

The X-axis interferometer 21 is a multi-axis interferometer having at least two optical axes and can measure an output value of each of the optical axes independently. The output value (measurement value) of this X-axis interferometer 21 is supplied to the main control apparatus 20, where the position of the measurement table MTB in the X-axial direction is measured based on the output value from the X-axis interferometer 21.

Since the measuring beam of the X-axis interferometer 21 is reflected at the reflecting surface 117S and the reflecting surface 27a of the fixed mirror 27 extending in the Y-axial direction, the X position of the measurement table MTB can be detected continuously without interruption even if the measurement table MTB moves such a long distance in the Y-axial direction as to go beyond the measurable range of the X-axis interferometer 46.

The X-axis interferometer 47 detects the position of the wafer table WTB in the X-axial direction at a wafer exchange position (loading position) LP.

The Y-axis interferometer 23 is a multi-axis interferometer having three optical axes and has a length measuring axis parallel to the Y-axial direction and a length measuring axis parallel to the X-axial direction. An output value (measurement value) of this Y-axis interferometer 23 is supplied to the main control apparatus 20, where not only the Y position of the mover 82 (stator 80) but also the amounts of pitching and the amounts of yawing of the bending mirrors for changing the direction of the beam 32 and 33 can be measured based on the output value from the Y-axis interferometer 23.

Similarly, the Y-axis interferometer 24 is a multi-axis interferometer having three optical axes, and has a length measuring axis parallel to the Y-axial direction and a length measuring axis parallel to the X-axial direction. An output value (measurement value) of this Y-axis interferometer 24 is supplied to the main control apparatus 20, where not only the Y position of the mover 84 (stator 81) but also the amounts of pitching and the amounts of yawing of the half mirrors 30 and 31 can be measured based on the output value from the Y-axis interferometer 24.

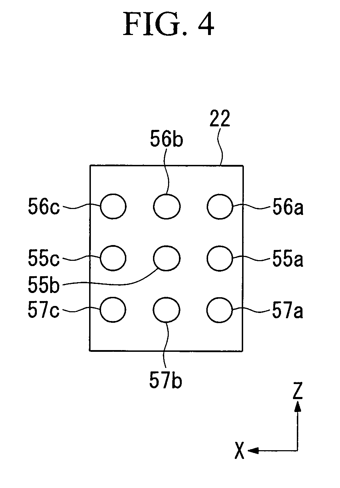

As shown in FIG. 4, the Z-axis interferometer 22 has light sending parts (light sources) 55a, 55b, and 55c (referred to as the light sending parts 55 as appropriate) for sending three detecting beams B1 to B3 (refer to FIGs. 2 and 3), which are parallel to the Y-axial direction and spaced apart at predetermined intervals in the X-axial direction; light receiving parts 56a, 56b, and 56c (referred to as the light receiving parts 56, as appropriate) provided to the +Z sides of the light sending parts 55a to 55c, respectively; and light receiving parts 57a, 57b, and 57c (referred to as the light receiving parts 57, as appropriate) provided to the -Z sides of the light sending parts 55a to 55c, respectively.

The half mirrors 30 and 31 are mounted on the mover 84 of the Y-axis linear motor at predetermined intervals in the X-axial direction and the Y-axial direction. The half mirror 30, as an optical separation system, divides the detecting beams Bland B2 sent from the light sending parts 55a and 55b, respectively, of the Z-axis interferometer 22 into reflected beams (second beams) BR1 and BR2 being changed the direction in parallel to the X-axial direction such that the Z positions (height positions in a direction orthogonal to the plane of motion 12a) are the same and transmission beams (first beams) BT1 and BT2, as an optical separation system. Optical paths spaced apart in the Y-axial direction, as shown in FIG. 3, are set for the reflected beams BR1 and BR2 produced as a result of dividing. The half mirror 31, as a second optical member, divides the detecting beam B3 sent from the light sending part 55c of the Z-axis interferometer 22 into a reflected beam BR3 being changed the direction in parallel to the X-axial direction and a transmission beam BT3.

The bending mirrors for changing the direction of the beam 32 and 33 are mounted on the mover 82 of the Y-axis linear motor and spaced apart at predetermined intervals in the X-axial direction and the Y-axial direction. The bending mirror 32 changes the direction of the transmission beam BT3, which has been sent from the light sending part 55c of the Z-axis interferometer 22 and has transmitted the half mirror 31, towards the wafer table WTB (hereinafter, the transmission beam BT3 after being reflected at the bending mirror 32 is referred to as the reflected beam BT3). The bending mirror 33 changes the direction of the transmission beams BT1 and BT2, which have been sent from the light sending parts 55a and 55b of the Z-axis interferometer 22 and have transmitted the half mirror 30, towards the wafer table WTB. For the reflected beams BT1 and BT2 (hereinafter, the transmission beams BT1 and BT2 after being reflected at the bending mirror 33 are referred to as the reflected beams BT1 and BT2), optical paths towards the wafer table WTB are set spaced apart in the Y-axial direction.

Furthermore, on the above-described mover 84, the temperature regulator 9 extending in the Y-axial direction is provided near the half mirrors 30 and 31. The temperature regulator 9 adjusts the temperature of the optical paths of the beams B1 to B3 (BR1 to BR3) by sending temperature-adjusted gas (e.g. air) whose temperature has been adjusted to the temperature in the exposure apparatus 100 towards the space around the half mirrors 30 and 31.

Similarly, on the mover 82, the temperature regulator 8 extending in the Y-axial direction is provided adjacent to the bending mirrors 32 and 33. The temperature regulator 8 adjusts the temperature of the optical paths of the beams B1 to B3 (BT1 to BT3) by sending temperature-adjusted gas (e.g. air) whose temperature has been adjusted to the temperature in the exposure apparatus 100 towards the space around the bending mirrors 32 and 33.

The prism (first optical system) 34 optically coupled with the bending mirror 32 is provided on the optical path of the reflected beam BT3, and the prisms (first optical systems) 35 and 36 optically coupled with the bending mirror 33 are provided on the optical paths of the reflected beams BT1 and BT2, respectively. As shown in FIG. 3, these prisms 34 to 36 are arranged on the edge of the wafer table WTB so as to form a triangle in plan view. In short, as is apparent from FIGs. 1 to 3, the prisms 34 to 36 are provided below the wafer holder 70 and on the wafer stage main body 28 so as not to protrude from the wafer holder 70 in the horizontal direction (X direction and Y direction). Similarly, a prism 34A and a prism 35A (which will be described later) are also provided below the wafer holder 70 and on the wafer stage main body 28 so as not to protrude from the wafer holder 70 in the horizontal direction (X direction and Y direction).

As shown in FIGs. 2 and 5, the prism 36 is disposed on the +Y side surface, adjacent to the -X side and +Z side end portion, of the wafer stage main body 28 and is optically coupled with the bending mirror 33 to divide, as an optical separation member, the incident reflected beam BT2 into a measuring beam (first measuring beam) BT21 parallel to the X-axial direction and a measuring beam (second measuring beam) BT22 that intersects the plane of motion 12a (at an angle of, for example, about 15° to the plane of motion 12a) to include a Z-axial-direction component. The prism 35 is not shown in FIG. 5 for the sake of convenience.

The measuring beam BT21 produced as a result of dividing is emitted towards the reflecting surface 27a of the fixed mirror 27 and is reflected at the reflecting surface 27a towards the prism 36. Furthermore, the measuring beam BT22 produced as a result of dividing is emitted towards the reflecting surface 27b and is reflected at the reflecting surface 27b towards the prism 36. The reflecting surface 27b is set to a size large enough to be capable to reflect the measuring beam BT22 (and measuring beams BT12 and BT32, which will be described later) towards the prism 36 (and the prisms 35A and 34A, which will be described later) even when the optical paths of the measuring beam BT22 and the measuring beams BT12 and BT32 move according to the movement of the wafer table WTB (wafer stage WST) in the X-axial direction.

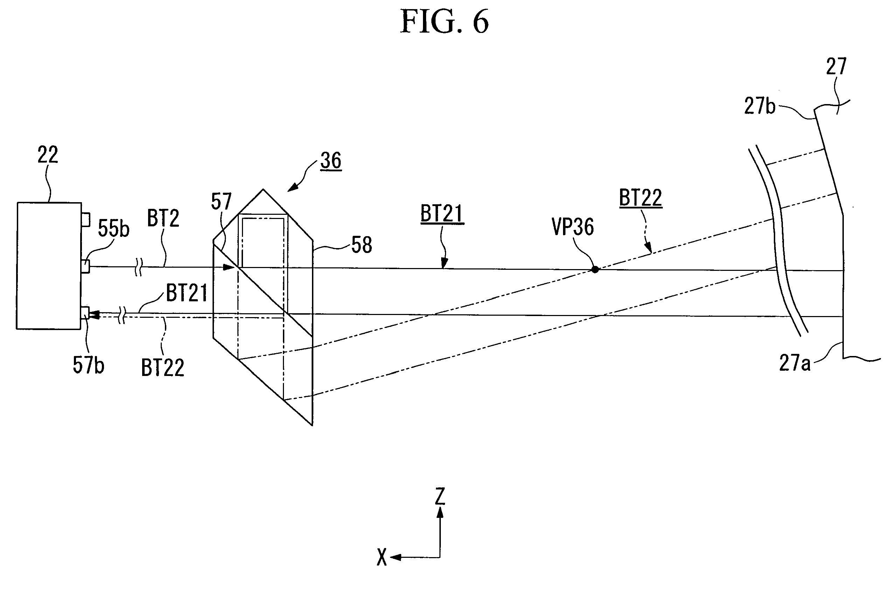

FIG 6 is a diagram showing an optical path of the reflected beam BT2.

The prism 36 is integrally formed of, for example, two prisms with a polarizing beam splitter 57 interposed therebetween and has a 1/4 $\lambda$ plate 58 provided on a surface that opposes the fixed mirror 27. The reflected beam BT2 that has been incident upon the prism 36 is divided by the beam splitter 57, and the beam that has transmitted the beam splitter 57 transmits the 1/4 $\lambda$ plate 58 and is emitted as the measuring beam BT21, as indicated by a solid line in the figure. The measuring beam BT21 reflected at the reflecting surface 27a transmits the 1/4 $\lambda$ plate 58 and is incident upon the prism 36. The measuring beam BT21 that has transmitted the 1/4 $\lambda$ plate 58 a second time is reflected in the beam splitter 57 and the prism 36 and is emitted from the prism 36 towards the reflecting surface 27a through the 1/4 $\lambda$ plate 58 at a Z position (-Z side) that is different from the previous emission position. The measuring beam BT21 reflected at the reflecting surface 27a is incident upon the prism 36 again via the 1/4 $\lambda$ plate 58, transmits the beam splitter 57, and is emitted from the prism 36. The Z position of the measuring beam BT21 emitted from the prism 36 is set at the Z position of the light receiving part 57b, and the measuring beam BT21 reflected at the reflecting surface 27a is received by the light receiving part 57b of the Z-axis interferometer 22 via the bending mirror 33 (not shown in the FIG. 6, but refer to FIG. 3).

On the other hand, the reflected beam BT2 that has been incident upon the prism 36 from the light sending part 55b and reflected at the beam splitter 57, as indicated by a two-dot chain line in the figure, is reflected in the prism 36, transmits the 1/4 $\lambda$ plate 58, and is emitted as the measuring beam BT22 towards the reflecting surface 27b such that it bounces off to the +Z side at an angle that causes the measuring beam BT22 to be orthogonal to the reflecting surface 27b. The measuring beam BT22 reflected at the reflecting surface 27b is incident upon the prism 36 through the 1/4 $\lambda$ plate 58. The measuring beam BT22 that has transmitted the 1/4 $\lambda$ plate 58 a second time is reflected in the prism 36, transmits the beam splitter 57, and is further reflected in the prism 36. Thereafter, the measuring beam BT22 is emitted from the prism 36 towards the reflecting surface 27b through the 1/4 $\lambda$ plate 58 at a Z position (-Z side) that is different from the previous emission position. The measuring beam BT22 reflected at the reflecting surface 27b is incident upon the prism 36 again via the 1/4 $\lambda$ plate 58, reflected in the prism 36 and at the beam splitter 57, and is emitted from the prism 36 at a Z position that is substantially the same position as the measuring beam BT21. The measuring beam BT22 emitted from the prism 36 is received by the light receiving part 57b of the Z-axis interferometer 22 via the bending mirror 33.

If the Z position of the prism 36, that is, the Z position of the wafer table WTB is constant, then the difference between the optical path lengths of the measuring beams BT21 and BT22 detected by the Z-axis interferometer 22 is constant. However, if the Z position of the wafer table WTB changes together with the prism 36, the optical path length of the measuring beam BT22 changes, which changes the difference between the optical path lengths of the measuring beams BT21 and BT22, accordingly. Thus, in the main control apparatus 20, a Z displacement of the wafer table WTB is detected based on a difference between the optical path lengths of the measuring beams BT21 and BT22 received by the light receiving part 57b of the Z-axis interferometer 22.

More specifically, if a bounce-off angle of the measuring beam BT22 (angle at which the measuring beam BT22 intersects the XY plane) emitted towards the reflecting surface 27b is $\theta$ and the amount of change in the optical path length of the measuring beam BT22 when the Z position of the wafer table WTB is changed is $\Delta L$, then a Z displacement $\Delta Z$ of the wafer table WTB (prism 36) is represented using the formula below.

$$\Delta Z = \Delta L/\sin\theta \quad \dots \quad (1)$$

In short, in the main control apparatus 20, the Z displacement $\Delta Z$ of the wafer table WTB can be detected by measuring the amount of change $\Delta L$ in the optical path length.

The Z displacement obtained with the prism 36 based on Formula (1) represents a Z displacement as detected at a measurement point VP36 (refer to FIGs. 5 and 6) where the measuring beam BT21 emitted in parallel to the XY plane intersects the measuring beam BT22 changed the direction towards the +Z side from the prism 36.

As shown in FIG 3, since the prisms 34 and 35 are provided on the wafer stage main body 28 disposed below (-Z side) the wafer table WTB, a measuring beam bouncing off the prisms to the +Z side towards the reflecting surface 27b may be blocked by the wafer table WTB depending on the positions of the prisms in the X-axial direction. For this reason, according to this embodiment, for the prisms 34 and 35, the direction of the reflected beams BT1 and BT3 incident upon the prisms 34 and 35 are changed the direction to the -Z side and then changed the direction by optical members to the +Z side towards the reflecting surface 27b.

More specifically, as shown in FIGs. 2 and 7, the prism 35 is disposed on the wafer stage main body 28 and is optically coupled with the bending mirror 33 to divide, as an optical separation member, the incident reflected beam BT 1 into a measuring beam (first measuring beam) BT11 parallel to the X-axial direction and the measuring beam (second measuring beam) BT12 that is directed towards the -Z side in parallel to the Z axis. The prism 36 is not shown in FIG. 7 for the sake of convenience. Below (-Z side) the prism 35 is provided the prism (second optical part) 35A which changes the direction of the measuring beam BT12 emitted from the prism 35 towards the reflecting surface 27b such that the measuring beam BT12 intersects the plane of motion 12a (e.g., at an angle of about 15° to the plane of motion 12a) and is orthogonal to the reflecting surface 27b. The Z position of the prism 35A is set at a height such that the measuring beam BT12 that has been changed the direction is not blocked by the wafer table WTB.

The prism 35 and the prism 35A are fixed on the wafer stage main body 28 via a spacer 42 and a spacer 42A, as shown in FIG. 1, so that the optical paths of the measuring beams BT11 and BT12 emitted via the prism 35 do not overlap the optical paths of the measuring beams BT21 and BT22 emitted via the prism 36, and the measuring beams BT11 and BT12 are apart from the measuring beams BT21 and BT22 in the Y-axial direction, as shown in FIG 3, to avoid interference with each other.

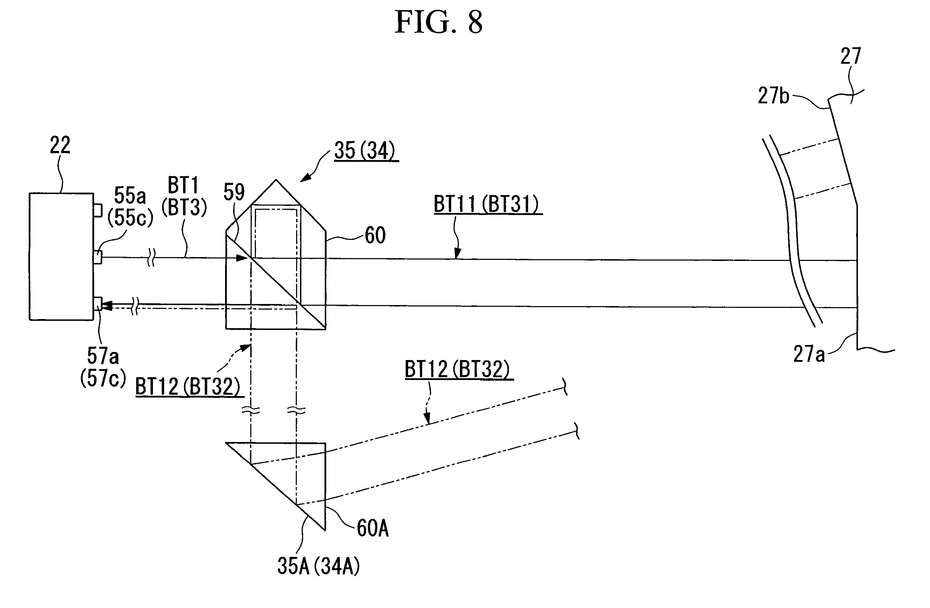

FIG. 8 is a diagram showing an optical path of the reflected beam BT1.

The prism 35 is integrally formed of, for example, two prisms with a polarizing beam splitter 59 interposed therebetween and has a 1/4 $\lambda$ plate 60 provided on a surface that opposes the fixed mirror 27. Furthermore, a 1/4 $\lambda$ plate 60A is provided on a surface of the prism 35A that opposes the fixed mirror 27.

The reflected beam BT1 that has been incident upon the prism 35 is divided by the beam splitter 59, and the beam that has transmitted the beam splitter 59 transmits the 1/4 $\lambda$ plate 60 and is emitted as the measuring beam BT11, as indicated by a solid line in the figure. The measuring beam BT11 reflected at the reflecting surface 27a transmits the 1/4$\lambda$ plate 60 and is incident upon the prism 35. The measuring beam BT11 that has transmitted the 1/4 $\lambda$ plate 60 a second time is reflected in the beam splitter 59 and the prism 35 and is emitted from the prism 35 towards the reflecting surface 27a through the 1/4 $\lambda$ plate 60 at a Z position (-Z side) that is different from the previous emission position. The measuring beam BT11 reflected at the reflecting surface 27a is incident upon the prism 35 again via the 1/4 $\lambda$ plate 60, transmits the beam splitter 59, and is emitted from the prism 35. The Z position of the measuring beam BT11 emitted from the prism 35 is set at the Z position of the light receiving part 57a, and the measuring beam BT11 reflected at the reflecting surface 27a is received by the light receiving part 57a of the Z-axis interferometer 22 via the bending mirror 33 (not shown in the FIG 8, but refer to FIG. 3).

On the other hand, the reflected beam BT1 that has been incident upon the prism 35 from the light sending part 55a and reflected at the beam splitter 59, as indicated by a two-dot chain line in the figure, is emitted from the prism 35 towards the -Z side as the measuring beam BT12, enters the prism 35A, and is changed the direction in the prism 35A. The measuring beam BT12 is then emitted towards the reflecting surface 27b via the 1/4 $\lambda$ plate 60A such that it bounces off to the +Z side at an angle that causes the measuring beam BT12 to be orthogonal to the reflecting surface 27b. The measuring beam BT12 reflected at the reflecting surface 27b transmits the 1/4 $\lambda$ plate 60A and is incident upon the prism 35A, changed the direction, and incident upon the prism 35. The measuring beam BT12 that has transmitted the 1/4 $\lambda$ plate 60A a second time transmits the beam splitter 59, is reflected in the prism 35, and transmits the beam splitter 59 again to be incident upon the prism 35A. The measuring beam BT12 that has been incident upon the prism 35A is emitted from the prism 35A towards the reflecting surface 27b through the 1/4 $\lambda$ plate 60A at a Z position (-Z side) that is different from the previous emission position. The measuring beam BT12 reflected at the reflecting surface 27b is incident upon the prism 35A again via the 1/4 $\lambda$ plate 60A and is changed the direction. Furthermore, the measuring beam BT12 is reflected at the beam splitter 59 and emitted from the prism 35 at a Z position that is substantially the same position as the measuring beam BT11. The measuring beam BT12 emitted from the prism 35 is received by the light receiving part 57a of the Z-axis interferometer 22 via the bending mirror 33.

In the main control apparatus 20, a Z displacement of the wafer table WTB can be detected using the above-described Formula (1) based on the difference between the optical path lengths of the measuring beams BT11 and BT12 received by the light receiving part 57a of the Z-axis interferometer 22.

In addition, as with the prism 36, the Z displacement obtained with the prism 35 based on the above-described Formula (1) represents a Z displacement as detected at a measurement point VP35 (refer to FIG 7) where the measuring beam BT11 emitted in parallel to the XY plane intersects the measuring beam BT12 changed the direction towards the +Z side from the prism 35.

Similarly, the prism 34 is disposed on the -Y side surface, at the substantially central point in the X-axial direction and adjacent to the +Z side end portion, of the wafer stage main body 28 and is optically coupled with the bending mirror 32 to divide, as an optical separation member, the incident reflected beam BT3 into a measuring beam (first measuring beam) BT31 parallel to the X-axial direction and the measuring beam (second measuring beam) BT32 that is directed towards the -Z side in parallel to the Z axis. Below (-Z side) the prism 34 is provided the prism (second optical part) 34A which changes the direction of the measuring beam BT32 emitted from the prism 34 towards the reflecting surface 27b such that the measuring beam BT32 intersects the plane of motion 12a (e.g., at an angle of about 15° to the plane of motion 12a) and is orthogonal to the reflecting surface 27b. The Z position of the prism 34A is set at a height such that the measuring beam BT32 that has been changed the direction is not blocked by the wafer table WTB.

The optical path of the reflected beam BT3 involving the prism 34 is the same as the optical path of the reflected beam BT1 shown in FIG. 8 and, therefore, will be described only briefly by providing symbols corresponding to the reflected beam BT3 in FIG. 8. The reflected beam BT3 from the light sending part 55c is incident upon the prism 34 via the bending mirror 32 and is divided into the measuring beam BT31, which is reflected at the reflecting surface 27a of the fixed mirror 27, and the measuring beam BT32, which is reflected at the reflecting surface 27b. Each of the measuring beams BT31 and BT32 is emitted from the prism 34 at a height biased to the -Z side from the reflected beam BT3 and is received by the light receiving part 57c of the Z-axis interferometer 22.

In the main control apparatus 20, a Z displacement of the wafer table WTB can be detected using the above-described Formula (1) based on the difference between the optical path lengths of the measuring beams BT3-1 and 32 received by the light receiving part 57c of the Z-axis interferometer 22.

As with the prisms 35 and 36, the Z displacement obtained with the prism 34 based on the above-described Formula (1) represents a Z displacement as detected at a measurement point VP34 (refer to FIG. 7) where the measuring beam BT31 emitted in parallel to the XY plane intersects the measuring beam BT32 changed the direction towards the +Z side from the prism 34.

Referring back to FIG. 3, the prisms (second optical systems) 39 and 38 are provided on the optical paths of the reflected beams BR1 and BR2, respectively, reflected at the half mirror 30, and the prism (second optical system) 37 is provided on the optical path of the reflected beam BR3. As shown in FIG. 3, these prisms 37 to 39 are arranged on the edge of the measurement table MTB so as to form a triangle in plan view. In short, as is apparent from FIGs. 1 to 3, the prisms 37 to 39 are provided below the plate 101 and on the measurement stage main body 52 so as not to protrude from the plate 101 in the horizontal direction (X direction and Y direction). Similarly, a prism 37A and a prism 39A (which will be described later) are also provided below the plate 101 and on the measurement stage main body 52 so as not to protrude from the plate 101 in the horizontal direction (X direction and Y direction).

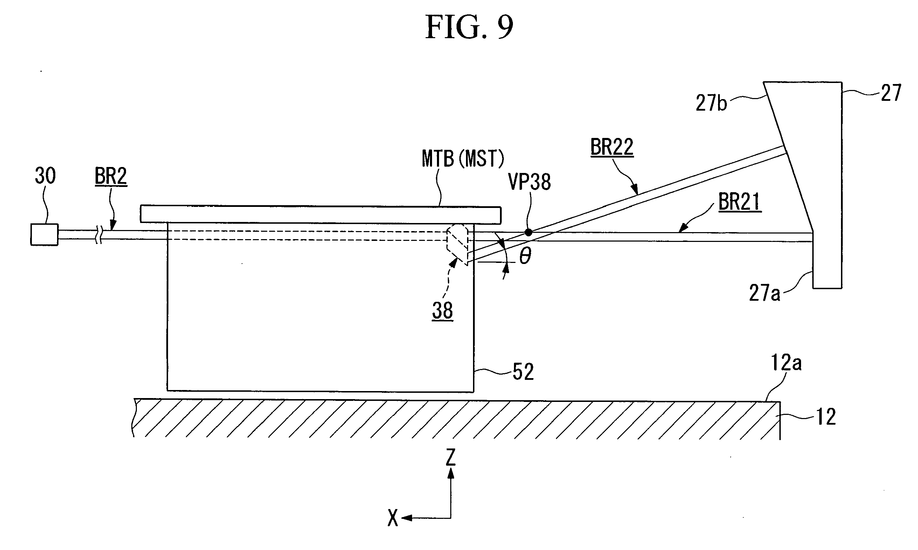

As shown in FIG 9, the prism 38 is disposed on the -Y side surface, adjacent to the -X side and +Z side end portion, of the measurement stage main body 52 and is optically coupled with the half mirror 30 to divide, as an optical separation member, the incident reflected beam BR2 into a measuring beam (first measuring beam) BR21 parallel to the X-axial direction and a measuring beam (second measuring beam) BR22 that is orthogonal to the reflecting surface 27b of the fixed mirror 27. The prism 37 is not shown in FIG. 9 for the sake of convenience.

The measuring beam BR21 produced as a result of dividing is emitted towards the reflecting surface 27a of the fixed mirror 27 and is reflected at the reflecting surface 27a towards the prism 38. Furthermore, the measuring beam BR22 produced as a result of dividing is emitted towards the reflecting surface 27b and is reflected at the reflecting surface 27b towards the prism 38. The reflecting surface 27b is set to a size large enough to be capable to reflect the measuring beam BR22 towards the prism 38 (and the prisms 39A and 37A, which will be described later) even when the optical paths of the measuring beam BR22 and measuring beams BR12 and BR32 (which will be described later) move according to the movement of the measurement table MTB (wafer stage WST) in the X-axial direction.

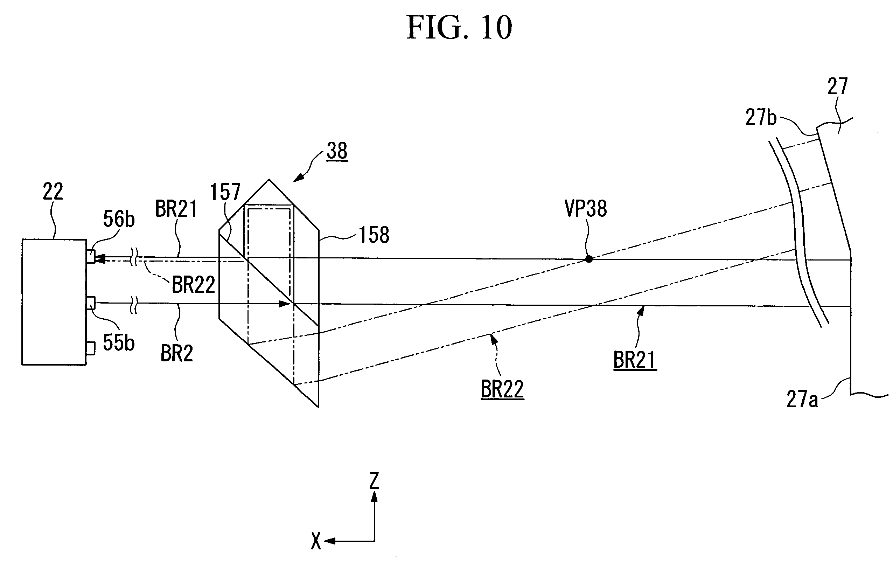

FIG 10 is a diagram showing an optical path of the reflected beam BR2.

In this embodiment, the prisms 37 to 39 are disposed to the +Z side from the prisms 34 to 36 by a distance equivalent to the difference between the height at which a beam from the Z-axis interferometer 22 is incident upon the prisms 34 to 36 on the above-described wafer stage WST and the height at which the beam is emitted towards the Z-axis interferometer 22 (i.e., the distance between the light sending parts 55a to 55c and the light receiving parts 57a to 57c). For this reason, a reflected beam is incident upon the prisms 37 to 39 at the position where a measuring beam is emitted from the prisms 34 to 36, and in contrast, the measuring beam is emitted from the position where the reflected beam is incident upon the prisms 34 to 36.

In short, the prism 38 is integrally formed of, for example, two prisms with a polarizing beam splitter 157 interposed therebetween and has a 1/4 λ plate 158 provided on a surface that opposes the fixed mirror 27. The reflected beam BR2 that has been incident upon the prism 38 is divided by the beam splitter 157, and the beam that has transmitted the beam splitter 157 transmits the 1/4 λ plate 158 and is emitted as the measuring beam BR211, as indicated by a solid line in the figure. The measuring beam BR21 reflected at the reflecting surface 27a transmits the 1/4 λ plate 158 and is incident upon the prism 38. The measuring beam BR21 that has transmitted the 1/4 λ plate 158 a second time is reflected in the beam splitter 157 and the prism 38 and is emitted from the prism 38 towards the reflecting surface 27a through the 1/4 λ plate 158 at a Z position (+Z side) that is different from the previous emission position. The measuring beam BR21 reflected at the reflecting surface 27a is incident upon the prism 38 again via the 1/4 λ plate 158, transmits the beam splitter 157, and is emitted from the prism 38. The Z position of the measuring beam BR21 emitted from the prism 38 is set at the Z position of the light receiving part 56b, which is different from that in the case of the wafer stage WST, and the measuring beam BR21 reflected at the reflecting surface 27a is received by the light receiving part 56b of the Z-axis interferometer 22 via the half mirror 30 (not shown in the FIG 10, but refer to FIG. 3).

On the other hand, the reflected beam BR2 that has been incident upon the prism 38 from the light sending part 55b and reflected at the beam splitter 157, as indicated by a two-dot chain line in the figure, is reflected in the prism 38, transmits the 1/4 λ plate 158, and is emitted as the measuring beam BR22 towards the reflecting surface 27b such that it bounces off to the +Z side at an angle that causes the measuring beam BR22 to be orthogonal to the reflecting surface 27b. The measuring beam BR22 reflected at the reflecting surface 27b transmits the 1/4λ plate 158 and is incident upon the prism 38. The measuring beam BR22 that has transmitted the 1/4 λ plate 158 a second time is reflected in the prism 38, transmits the beam splitter 157, and is further reflected in the prism 38. Thereafter, the measuring beam BR22 is emitted from the prism 38 towards the reflecting surface 27b through the 1/4 λ plate 158 at a Z position (+Z side) that is different from the previous emission position. The measuring beam BR22 reflected at the reflecting surface 27b is incident upon the prism 38 again via the 1/4 λ plate 158, reflected in the prism 38 and at the beam splitter 157, and is emitted from the prism 38 at a Z position that is substantially the same position as the measuring beam BR21. The measuring beam BR22 emitted from the prism 38 is received by the light receiving part 56b of the Z-axis interferometer 22 via the half mirror 30.

Also in the measurement stage MST, if the Z position of the prism 38, that is, the Z position of the measurement table MTB is constant, then the difference between the optical path lengths of the measuring beams BR21 and BR22 detected by the Z-axis interferometer 22 is constant. However, if the Z position of the measurement table MTB changes together with the prism 38, the optical path length of the measuring beam BR22 changes, which changes the difference between the optical path lengths of the measuring beams BR21 and BR22, accordingly. In the main control apparatus 20, a Z displacement of the measurement table MTB is detected using the above-described Formula (1) based on the difference between the optical path lengths of the measuring beams BR21 and BR22 received by the light receiving part 56b of the Z-axis interferometer 22.

Like the wafer stage WST, the Z displacement of the measurement stage MST obtained with the prism 38 based on Formula (1) represents a Z displacement as detected at a measurement point VP38 (refer to FIGs. 9 and 10) where the measuring beam BR21 emitted in parallel to the XY plane intersects the measuring beam BR22 changed the direction towards the +Z side from the prism 38.

A description of the prisms 37 and 39 will follow.

Also in the measurement stage MST, since the prisms are provided on the measurement stage main body 52 disposed-below (-Z side) the measurement table MTB, a measuring beam bouncing off the prisms to the +Z side towards the reflecting surface 27b may be blocked by the measurement table MTB depending on the positions of the prisms in the X-axial direction. For this reason, also according to this embodiment, for the prisms 37 and 39, the reflected beams BR1 and BR3 incident upon the prisms 37 and 39 are changed the direction to the -Z side and then changed the direction to the +Z side towards the reflecting surface 27b using the prisms 37A and 39A.

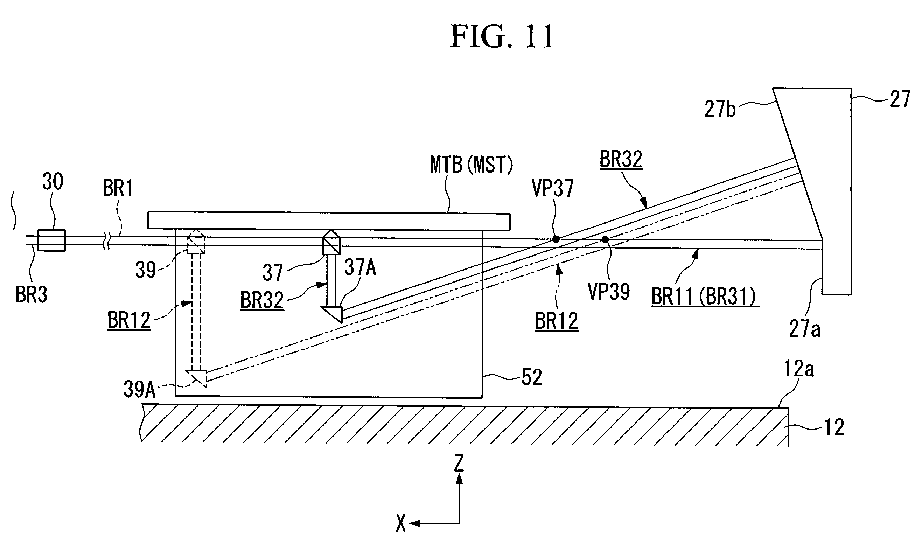

More specifically, as shown in FIG. 11, the prism 39 is disposed on the -Y side surface, adjacent to the +X side and +Z side end portion, of the measurement stage main body 52 and is optically coupled with the half mirror 30 to divide, as an optical separation member, the incident reflected beam BR1 into a measuring beam (first measuring beam) BR11 parallel to the X-axial direction and the measuring beam (second measuring beam) BR12 that is directed towards the -Z side in parallel to the Z axis. The prism 38 is not shown in FIG. 7 for the sake of convenience. Below (-Z side) the prism 39 is provided the prism (second optical part) 39A which changes the direction of the measuring beam BR12 emitted from the prism 39 towards the reflecting surface 27b such that the measuring beam BR12 is orthogonal to the reflecting surface 27b. The Z position of the prism 39A is set at a height such that the measuring beam BR12 that has been changed the direction is not blocked by the measurement table MTB.

The prism 39 and the prism 39A are fixed on the measurement stage main body 52 via a spacer 142 and a spacer 142A, as shown in FIG 1, so that the optical paths of the measuring beams BR11 and BR12 emitted via the prism 39 do not overlap the optical paths of the measuring beams BR21 and BR22 emitted via the prism 38, and the measuring beams BR11 and BR12 are apart from the measuring beams BR21 and BR22 in the Y-axial direction, as shown in FIG. 3, to avoid interference with each other.

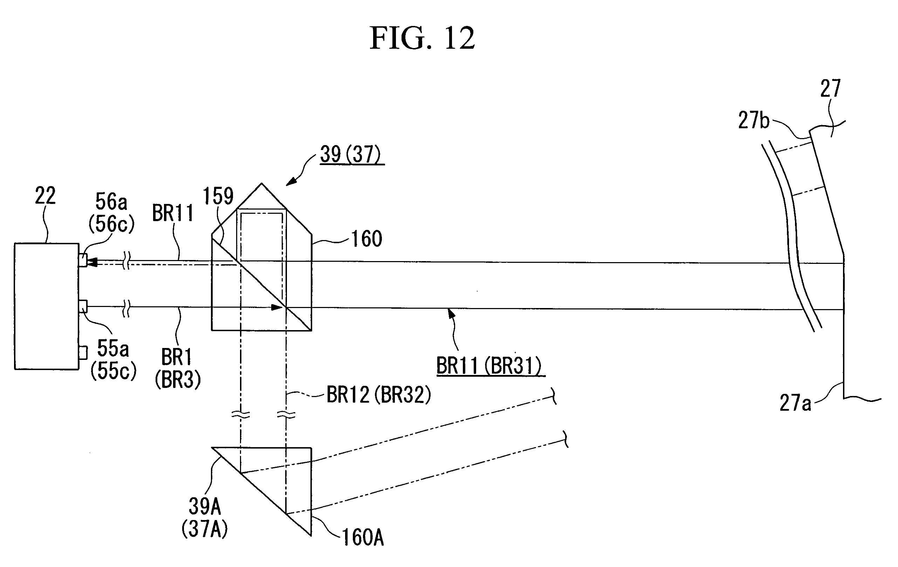

FIG. 12 is a diagram showing an optical path of the reflected beam BR1.

The prism 39 is integrally formed of, for example, two prisms with a polarizing beam splitter 159 interposed therebetween and has a 1/4 λ plate 160 provided on a surface that opposes the fixed mirror 27. Furthermore, a 1/4 λ plate 160A is provided on a surface of the prism 39A that opposes the fixed mirror 27.

The reflected beam BR1 that has been incident upon the prism 39 is divided by the beam splitter 159, and the beam that has transmitted the beam splitter 159 transmits the 1/4 λ plate 160 and is emitted as the measuring beam BR11, as indicated by a solid line in the figure. The measuring beam BR11 reflected at the reflecting surface 27a transmits the 1/4 λ plate 160 and is incident upon the prism 39. The measuring beam BR11 that has transmitted the 1/4 λ plate 160 a second time is reflected in the beam splitter 159 and the prism 39 and is emitted from the prism 39 towards the reflecting surface 27a through the 1/4 λ plate 160 at a Z position (+Z side) that is different from the previous emission position. The measuring beam BR11 reflected at the reflecting surface 27a is incident upon the prism 39 again via the 1/4 λ plate 160, transmits the beam splitter 159, and is emitted from the prism 39. The Z position of the measuring beam BR11 emitted from the prism 39 is set at the Z position of the light receiving part 56a, and the measuring beam BR11 reflected at the reflecting surface 27a is received by the light receiving part 56a of the Z-axis interferometer 22 via the half mirror 30 (not shown in the FIG. 12, but refer to FIG. 3).

On the other hand, the reflected beam BR1 that has been incident upon the prism 39 from the light sending part 55a and reflected at the beam splitter 159, as indicated by a two-dot chain line in the figure, is emitted from the prism 39 towards the -Z side as the measuring beam BR12, enters the prism 39A, and is changed the direction in the prism 39A. The measuring beam BR12 is then emitted towards the reflecting surface 27b via the 1/4 λ plate 160A such that it bounces off to the +Z side at an angle that causes the measuring beam BR12 to be orthogonal to the reflecting surface 27b. The measuring beam BR12 reflected at the reflecting surface 27b transmits the 1/4 λ plate 160A, is incident upon the prism 39A, changed the direction, and is incident upon the prism 39. The measuring beam BR12 that has transmitted the 1/4 λ plate 160A a second time transmits the beam splitter 159, is reflected in the prism 39, and transmits the beam splitter 159 again to be incident upon the prism 39A. The measuring beam BR12 that has been incident upon the prism 39A is emitted from the prism 39A towards the reflecting surface 27b through the 1/4 λ plate 160A at a Z position (+Z side) that is different from the previous emission position. The measuring beam BR12 reflected at the reflecting surface 27b is incident upon the prism 39A again via the 1/4 λ plate 160A, changed the direction, reflected at the beam splitter 159, and is emitted from the prism 39 at a Z position that is substantially the same position as the measuring beam BR11. The measuring beam BR12 emitted from the prism 39 is received by the light receiving part 56a of the Z-axis interferometer 22 via the half mirror 30.

In the main control apparatus 20, a Z displacement of the measurement table MTB can be detected using the above-described Formula (1) based on the difference between the optical path lengths of the measuring beams BR11 and BR12 received by the light receiving part 56a of the Z-axis interferometer 22.

The Z displacement obtained with the prism 39 based on Formula (1) represents a Z displacement as detected at a measurement point VP39 (refer to FIG. 11) where the measuring beam BR11 emitted in parallel to the XY plane intersects the measuring beam BR12 changed the direction towards the +Z side from the prism 39.

Similarly, the prism 37 is disposed on the +Y side surface, at the substantially central point in the X-axial direction and adjacent to the +Z side end portion, of the measurement stage main body 52 (refer to FIG. 2) and is optically coupled with the bending mirror 31 to divide, as an optical separation member, the incident reflected beam BR3 into a measuring beam (first measuring beam) BR31 parallel to the X-axial direction and the measuring beam (second measuring beam) BR32 that is directed towards the -Z side in parallel to the Z axis. Below (-Z side) the prism 37 is provided the prism (second optical part) 37A which changes the direction of the measuring beam BR32 emitted from the prism 37 towards the reflecting surface 27b such that the measuring beam BR32 is orthogonal to the reflecting surface 27b. The Z position of the prism 37A is set at a height such that the measuring beam BR32 that has been changed the direction is not blocked by the measurement table MTB.

The optical path of the reflected beam BR3 involving the prism 37 is the same as the optical path of the reflected beam BR1 shown in FIG. 12 and, therefore, will be described only briefly by providing symbols corresponding to the reflected beam BR3 in FIG. 12. The reflected beam BR3 from the light sending part 55c is incident upon the prism 37 via the half mirror 31 and is divided into the measuring beam BR31, which is reflected at the reflecting surface 27a of the fixed mirror 27, and the measuring beam BR32, which is reflected at the reflecting surface 27b. Each of the measuring beams BR31 and BR32 is emitted from the prism 37 at a height biased to the +Z side from the reflected beam BR3 and is received by the light receiving part 56c of the Z-axis interferometer 22.

In the main control apparatus 20, a Z displacement of the measurement table MTB can be detected using the above-described Formula (1) based on the difference between the optical path lengths of the measuring beams BR31 and 32 received by the light receiving part 56c of the Z-axis interferometer 22.

The Z displacement obtained with the prism 37 based on Formula (1) represents a Z displacement as detected at a measurement point VP37 (refer to FIG. 11) where the measuring beam BR31 emitted in parallel to the XY plane intersects the measuring beam BR32 changed the direction towards the +Z side from the prism 37.

In addition, with the exposure apparatus 100 of the present embodiment, the off-axis alignment system (hereinafter, generically referred to as the alignment system) ALG is provided to a holding member that holds the projection unit PU. For this alignment system ALG, a sensor of an image processing type FIA (Field Image Alignment) system is used that: irradiates a target mark with a broadband detection light beam, which does not photosensitize the resist on, for example, the wafer; uses an imaging device (for example, CCD) to capture an image of an index (an index pattern on an index plate provided in the alignment system ALG), which is not shown, and an image of a target mark that is imaged on a light receiving surface by the light reflected from that target mark; and outputs imaging signals thereof. The imaging signals from the alignment system ALG are supplied to the main control apparatus 20 shown in FIG 13.

Although not shown in FIG. 1, the exposure apparatus 100 of the present embodiment is provided with an oblique incidence type multi-focal point position detection system, similar to the one disclosed in, for example, Japanese Unexamined Patent Application, First Publication No. H6-283403 (corresponding U.S. Patent No. 5,448,332), which comprises an irradiation system 90a and a light receiving system 90b (refer to FIG 13).

FIG 13 shows major components of the control system of the exposure apparatus 100.

This control system principally comprises the main control apparatus 20, which comprises a microcomputer (or a workstation) that performs supervisory control of the entire apparatus. In addition, memory MEM and a display DIS, such as a CRT display (or a liquid crystal display), are connected to the main control apparatus 20.

The following explains the operation of the interferometer system 118 within the exposure apparatus 100 constituted as described above, referencing FIGs. 2 and 3.

In the present embodiment, the Y-axis interferometer 18 continuously radiates an interferometer beam onto the reflecting surface 17Y over the entire area of the range of motion of the wafer stage WST, and the Y-axis interferometer 16 continuously radiates an interferometer beam onto the reflecting surface 117Y over the entire area of the range of motion of the measurement stage MST. Accordingly, the positions of the stages WST and MST in the Y-axial direction are continuously managed by the main control apparatus 20 based on the measurement values of the Y-axis interferometers 16 and 18.

On the other hand, the main control apparatus 20 manages the X position of the wafer table WTB (wafer stage WST) based on the output values of the X-axis interferometer 46 just in the range wherein the reflecting surface 17X is irradiated with the interferometer beam from the X-axis interferometer 46 and manages the X position of the measurement table MTB (measurement stage MST) based on the output values of the X-axis interferometer 46 just in the range wherein the reflecting surface 117X is irradiated with the interferometer beam from the X-axis interferometer 46. Accordingly, when the X position of the wafer table WTB cannot be managed based on the output values of the X-axis interferometer 46, e.g., in the vicinity of the wafer exchange position (loading position) LP, it is managed based on the output values of the X-axis interferometer 47. On the other hand, when the X position of the measurement table MTB cannot be managed based on the output values of the X-axis interferometer 46, it is managed based on the output values of the X-axis interferometer 21.

A description of Z position measurement using the Z-axis interferometer 22 will follow.

When the wafer stage WST is driven along the plane of motion 12a in the X-axial direction relative to the stator 80, the relative positions between the bending mirrors 32 and 33 and the wafer stage WST change. However, optical coupling between the bending mirrors 32 and 33 and the prisms 34 to 36 is maintained because the relative positions between the bending mirrors 32 and 33 and the prisms 34 to 36 are substantially maintained in the Y-axial direction and the Z-axial direction. Therefore, the detecting beams B1 to B3 (reflected beams BT1 to BT3) emitted from the Z-axis interferometer 22 follow the movement of the wafer stage WST (wafer table WTB) and are incident upon the prisms 34 to 36. Then, the reflected beams BT1 to BT3 that have been incident upon the prisms 34 to 36 are divided into the measuring beams BT11, BT21, and BT31 and the measuring beams BT12, BT22, and BT32. These measuring beams are reflected at the reflecting surfaces 27a and 27b of the fixed mirror 27 and are received by the light receiving parts 57a to 57c even when the wafer stage WST moves in the X-axial direction.

Furthermore, when the wafer stage WST is driven along the plane of motion 12a by the Y-axis linear motors 82 and 83 in the Y-axial direction relative to the stators 86 and 87, the bending mirrors 32 and 33 provided on the mover 82 follow the movement of the wafer stage WST as the wafer stage WST moves. Therefore, the detecting beams B1 to B3 (reflected beams BT1 to BT3) follow the movement of the wafer stage WST (wafer table WTB) and are incident upon the prisms 34 to 36. Then, the reflected beams BT1 to BT3 that have been incident upon the prisms 34 to 36 are divided into the measuring beams BT11, BT21, and BT31 and the measuring beams BT12, BT22, and BT32. Even when the wafer stage WST moves in the Y-axial direction, these measuring beams are reflected at the reflecting surfaces 27a and 27b of the fixed mirror 27 and are received by the light receiving parts 57a to 57c because the reflecting surfaces 27a and 27b extend in the Y-axial direction and hence Z axis measurement is not interrupted.

Based on measuring beams received via the prisms 34 to 36, the main control apparatus 20 detects the Z position (Z displacement) of the wafer table WTB (wafer W) using the above-described Formula (1) for the position of each of the prisms 34 to 36. Furthermore, from the obtained Z displacements at the three locations, the main control apparatus 20 detects the amount of tilting, such as the amount of pitching and the amount of rolling, of the wafer table WTB.

More specifically, as shown in FIG. 14, if the prisms 35 and 36 are arranged along the X-axial direction and the measurement points VP34 to VP36 corresponding to the prisms 34 to 36, respectively, are arranged at the three vertices of a triangle where the vertices are apart by a distance Lx in the X-axial direction and by a distance Ly in the Y-axial direction, then the amount of rolling θy and the amount of pitching θx of the wafer table WTB can be calculated using the formulas below.

$$\theta y = (Z36\text{-}Z35)/Lx \quad ... \quad (2)$$

$$\theta x = (Z34\text{-}(Z36\text{+}Z35)/2)/Ly \quad ... \quad (3)$$

where Z34 to Z36 represent the Z displacements at the measurement points VP34 to VP36, respectively.

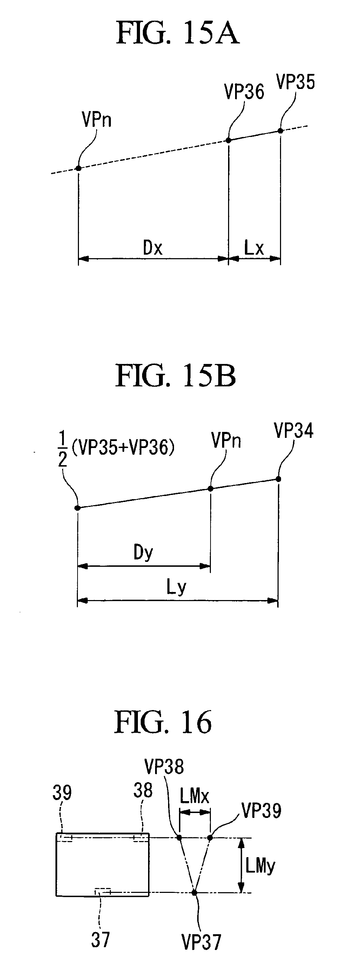

Furthermore, as shown in FIGs. 15A and 15B, the Z displacement Zn at any position VPn, such as a position in the wafer table WTB, can be obtained using the following formula.

$$Zn = Z36\text{-}(Z35\text{-}Z36)\times Dx/Lx\text{+}\{Z34\text{-}(Z36\text{+}Z35)/2\}\times Dy/Ly$$

$$= Z36\times(Lx\text{+}Dx)/Lx\text{-}Z35\times(Dx/Lx)\text{+}\{Z34\text{-}(Z36\text{+}Z35)/2\}\times Dy/Ly \quad ... \quad (4)$$

On the other hand, if pitching is produced in the mover 82 when the wafer stage WST is driven in the Y axial direction, the Z position, the amount of rolling, and the amount of pitching of the wafer table WTB that are detected using the detecting beams B1 to B3 (reflected beams BT1 to BT3) via the above-described bending mirrors 32 and 33 suffer from a pitching error (optical error) associated with the bending mirrors 32 and 33. To overcome this problem, the main control apparatus 20, serving as a correction apparatus, obtains the amount of pitching in the bending mirrors 32 and 33 based on two length measuring axes of the Y-axis interferometer 23 that are parallel to the Y-axial direction and, using this obtained amount of pitching, corrects the Z position, the amount of rolling, and the amount of pitching of the wafer table WTB.

Alternatively, the amount of yawing of the bending mirrors 32 and 33 may be obtained using two length measuring axes parallel to the X-axial direction (one of which also serves as a length measuring axis for the Y axis), in addition to the two length measuring axes parallel to the Y-axial direction, to correct the position of the wafer table WTB according to the amount of pitching and the amount of yawing of the bending mirrors 32 and 33.

Thereafter, the main control apparatus 20 drives the three actuators supporting the wafer table WTB based on the obtained Z position, amount of rolling, and amount of pitching of the wafer table WTB, sets the surface of the wafer W at the focal point position of the projection optical system PL, and performs leveling adjustment so that the surface of the wafer W becomes orthogonal to the optical axis AX of the illumination light IL.

Like the wafer stage WST, when the measurement stage MST is driven along the plane of motion 12a in the X-axial direction relative to the stator 81, the relative positions between the half mirrors 30 and 31 and the measurement stage MST change. However, optical coupling between the half mirrors 30 and 31 and the prisms 37 to 39 is maintained because the relative positions between the half mirrors 30 and 31 and the prisms 37 to 39 are substantially maintained in the Y-axial direction and the Z-axial direction. Therefore, the detecting beams B1 to B3 (reflected beams BR1 to BR3) emitted from the Z-axis interferometer 22 follow the movement of the measurement stage MST (measurement table MTB) and are incident upon the prisms 37 to 39. Then, the reflected beams BR1 to BR3 that have been incident upon the prisms 37 to 39 are divided into the measuring beams BR11, BR21, and BR31 and the measuring beams BR12, BR22, and BR32. These measuring beams are reflected at the reflecting surfaces 27a and 27b of the fixed mirror 27 and are received by the light receiving parts 56a to 56c even when the measurement stage MST moves in the X-axial direction.

Furthermore, when the measurement stage MST is driven along the plane of motion 12a by the Y-axis linear motors 84 and 85 in the Y-axial direction relative to the stators 86 and 87, the half mirrors 30 and 31 provided on the mover 84 follow the movement of the measurement stage MST as the measurement stage MST moves. Therefore, the detecting beams B1 to B3 (reflected beams BR1 to BR3) follow the movement of the measurement stage MST (measurement table MTB) and are incident upon the prisms 37 to 39. Then, the reflected beams BR1 to BR3 that have been incident upon the prisms 37 to 39 are divided into the measuring beams BR11, BR21, and BR31 and the measuring beams BR12, BR22, and BR32. Even when the measurement stage MST moves in the Y-axial direction, these measuring beams are reflected at the reflecting surfaces 27a and 27b of the fixed mirror 27 and are received by the light receiving parts 57a to 57c because the reflecting surfaces 27a and 27b extend in the Y-axial direction and hence Z axis measurement is not interrupted.

Based on measuring beams received via the prisms 37 to 39, the main control apparatus 20 detects the Z position (Z displacement) of the measurement table MTB using the above described Formula (1) for the position of each of the prisms 37 to 39. Furthermore, from the obtained Z displacements at the three locations, the main control apparatus 20 detects the amount of tilting, such as the amount of pitching and the amount of rolling, of the measurement table MTB.

More specifically, as shown in FIG 16, if the prisms 38 and 39 are arranged along the X-axial direction and the measurement points VP37 to VP39 corresponding to the prisms 37 to 39, respectively, are arranged at the three vertices of a triangle where the vertices are apart by a distance LMx in the X-axial direction and by a distance LMy in the Y-axial direction, then the amount of rolling θy and the amount of pitching θx of the measurement table MTB can be calculated using the formulas below.

$$\theta y = (Z39 - Z38)/LMx \quad ... \quad (5)$$

$$\theta x = (Z37 - (Z39 + Z38)/2)/LMy \quad ... \quad (6)$$

where Z37 to Z39 represent the Z displacements at the measurement points VP37 to VP39, respectively.

On the other hand, if pitching is produced in the mover 84 when the measurement stage MST is driven in the Y-axial direction, the Z position, the amount of rolling, and the amount of pitching of the measurement table MTB that are detected using the detecting beams B1 to B3 (reflected beams BR1 to BR3) via the above-described half mirrors 30 and 31 suffer from a pitching error (optical error) associated with the half mirrors 30 and 31. To overcome this problem, the main control apparatus 20, serving as a correction apparatus, obtains the amount of pitching in the half mirrors 30 and 31 based on two length measuring axes of the Y-axis interferometer 24 that are parallel to the Y-axial direction and, using this obtained amount of pitching, corrects the Z position, the amount of rolling, and the amount of pitching of the measurement table MTB.

Alternatively, the amount of yawing of the half mirrors 30 and 31 may be obtained using two length measuring axes parallel to the X-axial direction (one of which also serves as a length measuring axis for the Y axis), in addition to the two length measuring axes parallel to the Y-axial direction, to correct the position of the measurement table MTB according to the amount of pitching and the amount of yawing of the half mirrors 30 and 31.

Thereafter, the main control apparatus 20 drives the three actuators supporting the measurement table MTB based on the obtained Z position, amount of rolling, and amount of pitching of the measurement table MTB, sets the surface of the plate 101 at a predetermined Z position, and performs leveling adjustment so that the surface of the plate 101 becomes orthogonal to the optical axis AX of the illumination light IL.

When the wafer stage WST and the measurement stage MST are driven, temperature-adjusted air is blown from the temperature regulators 8 and 9 to adjust the temperature in the space where the bending mirrors 32 and 33 and the half mirrors 30 and 31 perform follow-up movement. Therefore, adverse effects, such as air currents, that can result from heat generated by the detecting beams B1 to B3 (measuring beams BT11, 12, BT21, 22, BT31, 32, BR11, BR12, BR21, BR22, BR31, and BR32) can be prevented.

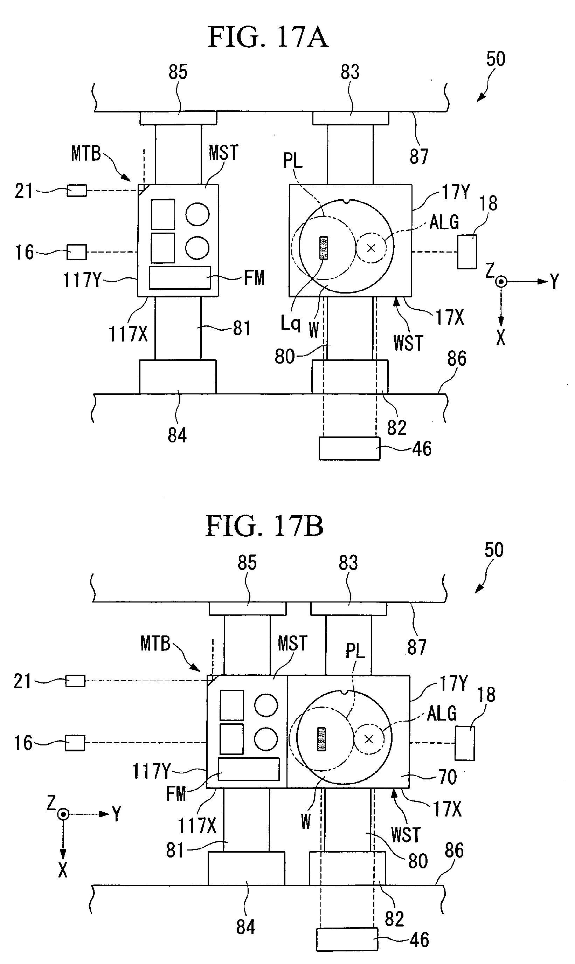

Next, parallel processing using the wafer stage WST and the measurement stage MST will be described with reference to FIGs. 17 to 19.

During the following operation, open/close control of each valve of the liquid supply apparatus 288 and the liquid recovery apparatus 292 in the immersion apparatus 132 is performed by the main control apparatus 20 as described above so that water always resides directly below the front lens 91 of the projection optical system PL. However, a description of control of the liquid supply apparatus 288 and the liquid recovery apparatus 292 is omitted below to simply the explanation.

FIG. 17A shows the wafer W (e.g., the last wafer of one lot in this example) on the wafer stage WST being subjected to a step-and-scan type exposure operation. At this time, the measurement stage MST is retracted at a predetermined standby position where it does not interfere (come into contact) with the wafer stage WST.

The above-described exposure process is performed by the main control apparatus 20 based on the result of wafer alignment, e.g., enhanced global alignment (EGA), which is performed in advance, and on the latest baseline measurement result of the alignment system ALG by repetitively performing an inter-shot movement operation, wherein the wafer stage WST is moved to a scanning start position (acceleration start position) in order to expose each shot region on the wafer W, and a scanning exposure operation that transfers a pattern, which is formed in the reticle R, to each shot region through a scanning exposure technique.

Furthermore, the wafer W is subjected to focal point position detection, as well as wafer alignment, by the use of the irradiation system 90a and the light receiving system 90b so that the surface of the wafer W is set at the focal point position of the projection optical system PL. For focal point position detection for the wafer W, the position on the wafer irradiated with detection light from the irradiation system 90a is set at a point that is not filled with water, and the shot region to be exposed first (first shot region) is subjected to focal point position detection at a point before the shot region is immersed in water. Emission of detection light from the irradiation system 90a is continued also during this exposure process of the first shot region to acquire focal point position information in the shot region being irradiated with the detection light. Thereafter, when an exposure process of the subsequent shot region (second shot region) is to be carried out after the completion of the exposure process of the first shot region, the surface in the second shot region is positioned at the focal point position of the projection optical system-PL using the focal point position information acquired during the exposure process of the first shot region.

In this manner, positioning of the second shot region and the subsequent shot regions to the focal point position of the projection optical system PL is carried out by the use of the focal point position information detected and acquired during the previous exposure process. In other words, since it is not necessary to provide an independent step of detecting focal point position information, the throughput can be enhanced.

Here, the above-described inter-shot movement operation where the wafer stage WST is moved is achieved by the main control apparatus 20 controlling the driving of the X-axis linear motor 80 and the Y-axis linear motors 82 and 83 while the main control apparatus 20 monitors measurement values of the interferometers 18 and 46. Furthermore, in order to achieve the above-described scanning exposure, the main control apparatus 20 controls the reticle stage drive part 11 and the Y-axis linear motors 82 and 83 (and the X-axis linear motor 80) while monitoring measurement values of the interferometers 18 and 46 and the reticle interferometer 116; performs relative scanning of the reticle R (reticle stage RST) and the wafer W (wafer stage WST) with respect to the Y-axial direction; and performs synchronous uniform movement of the reticle R (reticle stage RST) and the wafer W (wafer stage WST) in the illumination area of the illumination light IL with respect to the Y-axial direction during the period of uniform movement from after the end of acceleration to before the start of deceleration of the above-described relative scanning operation. The above-described exposure operation is performed with water held between the front lens 91 and the wafer W.

Thereafter, when exposure of the wafer W ends on the wafer stage WST, the main control apparatus 20 controls the Y-axis linear motors 84 and 85 and the X-axis linear motor 81 based on measurement values of the interferometers 16 and 21 and moves the measurement stage MST (measurement table MTB) to the position shown in FIG. 17B. In the state of FIG 17B, the +Y side surface of the measurement table MTB is in contact with the -Y side surface of the wafer table WTB. Alternatively, the measurement table MTB may be positioned, for example, about 300 $\mu$m (a gap small enough to achieve surface tension of water that prevents the water from leaking) apart from the wafer table WTB in the Y-axial direction while monitoring the measurement values of the interferometers 16 and 18.

As described above, the prisms 34 to 36, the prism 34A, and the prism 35A are provided below the wafer holder 70 and on the wafer stage main body 28 so as not to protrude from the wafer holder 70 in the horizontal direction (X direction and Y direction). Similarly, the prisms 37 to 39, the prism 37A, and the prism 39A are also provide below the plate 101 and on the measurement stage main body 52 so as not protrude from the plate 101 in the horizontal direction (X direction and Y direction). Therefore, even though the measurement table MTB is brought near the wafer table WTB as described above, the prism 34 does not come into contact with the prism 37.

Furthermore, the prisms 34 to 39, the prism 34A, the prism 35A, the prism 37A, and the prism 39A can be prevented from becoming wet with water.

Thereafter, the main control apparatus 20 starts the operation of driving both the stages WST and MST in the +Y direction while keeping the positional relationship in Y-axial direction between the wafer table WTB and the measurement table MTB.

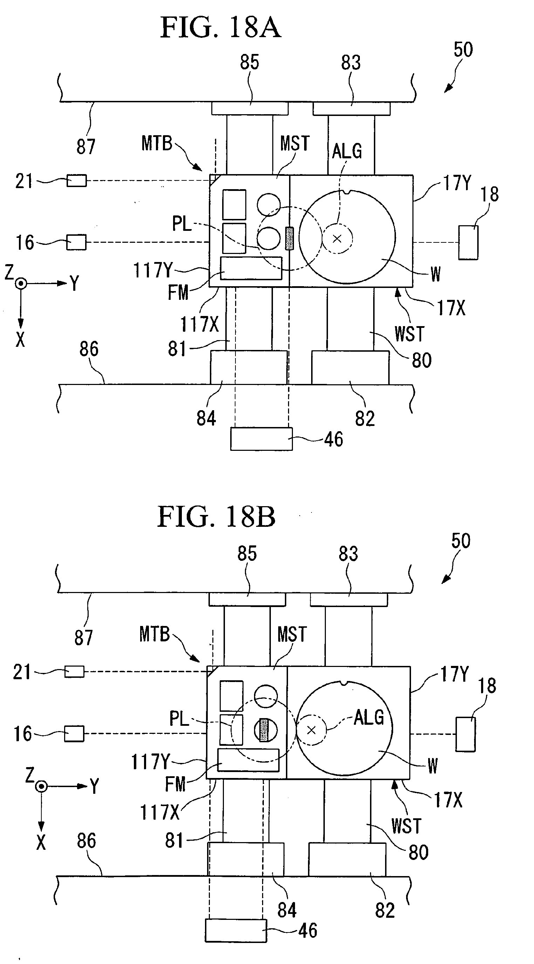

In the state of FIG. 17B where the wafer stage WST and the measurement stage MST have been driven by the main control apparatus 20 at the same time in this manner, the water held between the front lens 91 of the projection unit PU and the wafer W sequentially moves from the wafer W to the wafer holder 70 and to the measurement table MTB as the wafer stage WST and the measurement stage MST move towards the +Y side. During the above-described movement, the wafer table WTB and the measurement table MTB remain in contact with each other. FIG. 18A shows a state where water exists on both the wafer stage WST and the measurement stage MST simultaneously during the above-described movement, that is, a state just before the water is transferred from the wafer stage WST to the measurement stage MST.

In the state of FIG. 18A, when the wafer stage WST and the measurement stage MST are further driven simultaneously in the +Y direction by a predetermined distance, the water is held between the measurement stage MST and the front lens 91, as shown in FIG 18B. Prior to this, the main control apparatus 20 resets the X-axis interferometer 46 at any time the reflecting surface 117X of the measurement table MTB can be irradiated with an interferometer beam from the X-axis interferometer 46. Furthermore, in the state of FIG. 18B, the main control apparatus 20 manages the X position of the wafer table WTB (wafer stage WST) based on a measurement value of the X-axis interferometer 47.

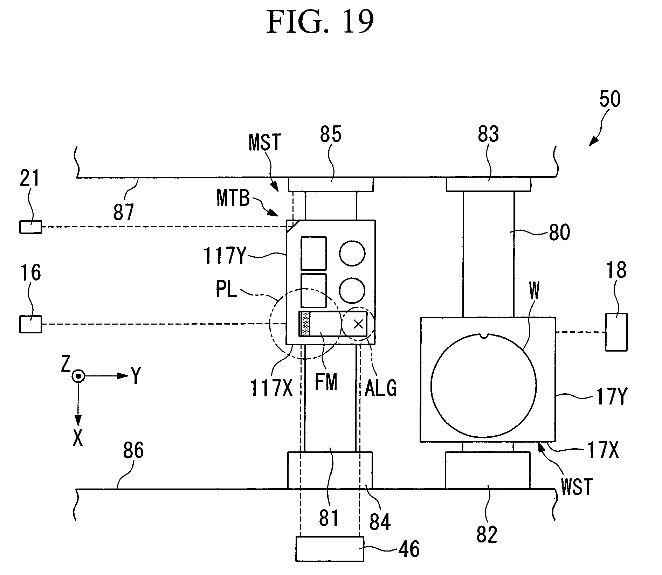

Next, while monitoring the position of the wafer stage WST based on measurement values of the interferometers 18 and 47, the main control apparatus 20 controls the driving of the linear motors 80, 82, and 83 to move the wafer stage WST to the predetermined wafer exchange position, where the current wafer is replaced with the first wafer of the subsequent lot. At the same time, the main control apparatus 20 performs predetermined measurement using the measurement stage MST as required. One example of this measurement is baseline measurement of the alignment system ALG which is carried out after reticle exchange on the reticle stage RST. More specifically, the main control apparatus 20 detects the positional relationship between the pair of first reference marks in the fiducial mark area FM provided on the plate 101 of the measurement table MTB and the corresponding reticle alignment marks on the reticle by simultaneously detecting the pair of first reference marks and the corresponding reticle alignment marks using the above-described reticle alignment detection systems RAa and RAb. At the same time, the main control apparatus 20 detects the positional relationship between the center of detection of the alignment system ALG and a second reference mark in the above-described fiducial mark area FM by detecting the second reference mark using the alignment system ALG Then, the main control apparatus 20 obtains the distance between the center of projection of a reticle pattern by the projection optical system PL and the center of detection by the alignment system ALG, that is, the baseline of the alignment system ALG, based on the positional relationship between the above-described pair of first reference marks and the corresponding reticle alignment marks; the positional relationship between the center of detection of the alignment system ALG and the second reference mark; and the positional relationship between a known pair of first reference mark and second reference mark. The state at this time is show in FIG. 19.

With the above-described baseline measurement of the alignment system ALG, so-called reticle alignment is carried out by forming a plurality of reticle alignment marks on the reticle; forming a plurality of pairs of first reference marks, corresponding to these reticle alignment marks, in the fiducial mark area FM; and measuring the relative positions between at least two pairs of the first reference marks and the corresponding reticle alignment marks using the reticle alignment systems RAa and RAb while step-moving the reticle stage RST and the wafer stage WST in the Y-axial direction.

In this case, detection of marks using the reticle alignment systems RAa and RAb is carried out via the projection optical system PL and water.

Thereafter, when the procedure on the above-described stages WST and MST ends, the main control apparatus 20 brings the measurement stage MST into contact with the wafer stage WST and, while keeping the contact state, drives them in the XY plane to return the wafer stage WST to directly below the projection unit. During this movement, the main control apparatus 20 also resets the X-axis interferometer 46 at any time the reflecting surface 17X of the wafer table WTB can be irradiated with an interferometer beam from the X-axis interferometer 46. Then, on the wafer stage WST, wafer alignment of the exchanged wafer, that is, detection of an alignment mark on the exchanged wafer is carried out by the alignment system ALG to calculate the position coordinates of a plurality of shot regions on the wafer.

Thereafter, conversely to the above, the main control apparatus 20 moves the wafer stage WST (wafer) to below the projection optical system PL by driving the wafer stage WST and the measurement stage MST simultaneously in the -Y direction while maintaining the positional relationship in the Y-axial direction between the stages WST and MST. Then, the main control apparatus 20 retracts the measurement stage MST at a predetermined position.

Then, the main control apparatus 20 applies a step-and-scan type exposure operation to the new wafer in the same manner as described above to sequentially transfer a reticle pattern to a plurality of shot regions on the wafer.

Although baseline measurement has been described above as a measuring operation, the measuring operation is not limited to baseline measurement. A different measuring operation, such as illuminance measurement, illuminance-irregularity measurement, aerial-image measurement, and wavefront-aberration measurement, may be performed using the measuring instrument group 43 of the measurement stage MST while wafer exchange is being carried out on the wafer stage WST to reflect the measurement result upon the subsequent exposure of the wafer. More specifically, for example, the projection optical system PL can be adjusted by the above-described imaging characteristic correction controller 381-based on such a measurement result.

As described above, according to this embodiment, when position detection is to be performed for the wafer stage WST (wafer table WTB) or the measurement stage MST (measurement table MTB) having a long stroke in the Y-axial direction, the detecting beams B1 to B3 can be made to follow the movement of the wafer table WTB and the measurement table MTB without interrupting measurement as a result of the bending mirrors 32 and 33 and the half mirrors 30 and 31 being mounted on the movers 82 and 84, respectively. For this reason, it is not necessary to provide each stage with a movable mirror extending in the Y-axial direction. This prevents the stages from becoming heavy or large and, accordingly, prevents the movement performance from degrading. Furthermore, it is not necessary to additionally provide an interferometer for interferometer changeover, and therefore, an unwanted increase in the number of measuring axes can be avoided. This contributes to a further decrease in the cost. Furthermore, according to this embodiment, when a detecting beam is made to follow the movement of the wafer stage WST or the measurement stage MST, the temperature of the space in which the bending mirrors 32 and 33 and the half mirrors 30 and 31 follow the movement is adjusted by the temperature regulators 8 and 9. Therefore, heat generated by the beam can always be controlled, which prevents adverse effects by heat, such as air currents, and thereby achieves high-accuracy position measurement.

In addition, according to this embodiment, the Z positions of the wafer table WTB and the measurement table MTB can be detected with a simple structure where a beam is divided into a measuring beam parallel to the X axis and a measuring beam including a Z-direction component by the use of the prisms 34 to 36 and 37 to 39 optically coupled with the bending mirrors 32 and 33 and the half mirrors 30 and 31 so that the measuring beams are reflected at the reflecting surfaces 27a and 27b, respectively. This contributes to a decrease in the cost of the apparatus. Furthermore, since these reflecting surfaces 27a and 27b are formed integrally as the fixed mirror 27, the cost can be suppressed compared in the case where these surfaces are provided separately. Furthermore, according to this embodiment, since the fixed mirror 27 is disposed not above the wafer table WTB and the measurement table MTB but on a side outside the base plate 12 in plan view, the layout of the projection optical system and a measuring instrument used for position measurement of a wafer, which are usually provided above these tables (base plate 12), is not adversely affected. This prevents an increase in the size of the apparatus. In addition, according to this embodiment, since the fixed mirror 27 used for Z measurement is shared by the prisms 34 to 36 of the wafer stage WST and the prisms 37 to 39 of the measurement stage MST, the cost is reduced compared with a case where reflecting mirrors are provided separately.

On the other hand, in this embodiment, the amount of tilting such as the amount of pitching and the amount of rolling, as well as the Z positions, of the stages WST and MST, can be measured easily by measuring Z positions at three locations on each of the stages WST and MST. In addition, according to this embodiment, an optical error in, for example, the amount of pitching resulting from the movement of the movers 82 and 84 is measured when a Y-axis linear motor is to be driven to correct the amount of tilting of the tables WTB and MTB. Therefore, not only can the surface of the wafer W be set at the focal point position of the projection optical system PL with high accuracy, but also the surface of the wafer W can be made orthogonal to the optical axis AX of the illumination light IL. This ensures higher-accuracy transfer of a reticle pattern. Furthermore, according to this embodiment, since the amount of tilting, such as the amount of pitching or the amount of rolling, can be detected through Z position measurement of the stages WST and MST, detection of the amount of pitching or the amount of rolling by the use of the Y-axis interferometers 16, 18, and 21 and the X-axis interferometers 46 and 47 can be eliminated. As a result, the thickness of the wafer table WTB and the measurement table MTB can be reduced by reducing the number of measuring axes in the Z direction associated with these interferometers. This leads to a decrease in the weight of the stages WST and MST.

In addition, for the wafer stage WST and the measurement stage MST in this embodiment, the compact Z-axis interferometer 22 where the light sending parts 55a to 55c are shared can be constructed, as shown in FIG. 4, by equalizing the height positions of the detecting beams B1 to B3 entering the prisms 34 to 36 and 37 to 39 and by varying the height positions in the Z direction between measuring beams emitted from the prisms 34 to 36 and measuring beams emitted from the prisms 37 to 39. This can contribute to a further reduction in the size of the stage apparatus 50 and the exposure apparatus 100.

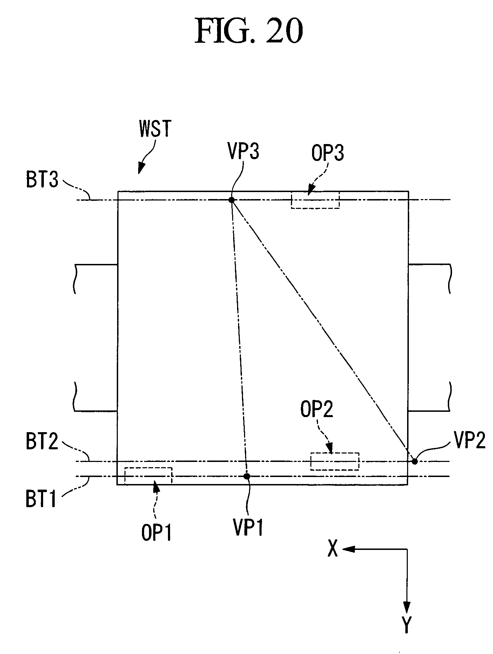

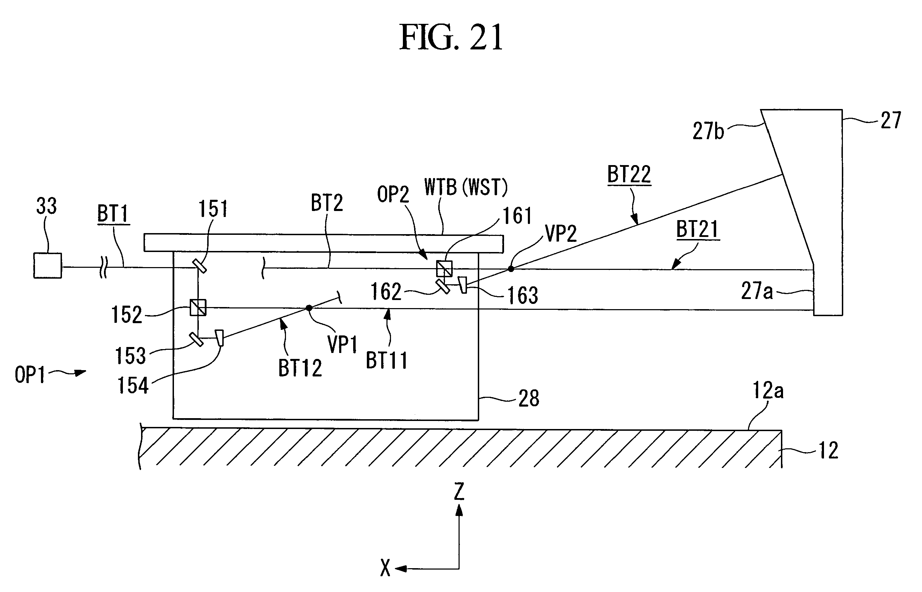

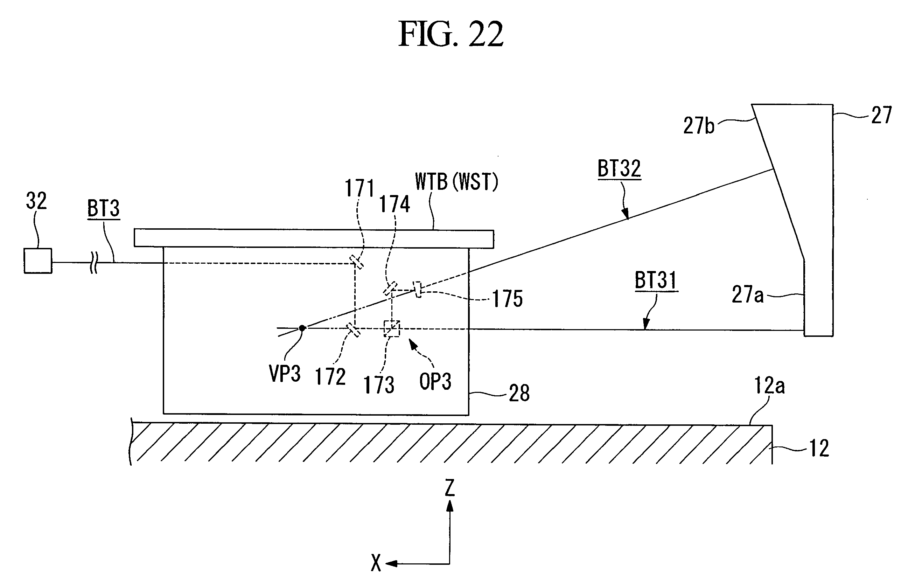

A second embodiment of a stage apparatus according to the present invention will now be described with reference to FIGs. 20 to 22. FIG 20 is a partial plan view in schematic form showing the structure of the wafer stage WST. As shown in this figure, according to this embodiment, three optical element groups OP 1 to OP3 constituting the interferometer system 118 are provided on the wafer stage WST in order to measure the Z displacement (as well as the amount of pitching and the amount of rolling) of the wafer stage WST. Although the optical element groups OP1 to OP3 shown in the second embodiment can be applied to the measurement stage MST, as well as to the wafer stage WST, only the wafer stage WST is described in this embodiment. Furthermore, only the optical axes of measuring beams are shown for the optical element groups OP 1 to OP3 in FIGs. 21 and 22.

In these figures, the same components as those referred to in the first embodiment shown in FIGs. 1 to 19 are denoted by the same symbols, and a description thereof will be omitted.

The optical element group OP 1 is provided on the +Y side surface of the wafer stage main body 28, on the optical path of the measuring beam BT1, and adjacent to the +X side of the wafer stage main body 28. The optical element group OP 1 includes a bending mirror (first optical member) 151 optically coupled with the bending mirror 33, a beam splitter (optical separation member) 152, a bending mirror 153, and a prism (second optical part) 154.

The bending mirror 151 changes the direction of the incident measuring beam BT1 towards the -Z direction so that the measuring beam BT1 is incident upon the beam splitter 152. The beam splitter 152 divides the measuring beam BT1 changed the direction by the bending mirror 151 into the measuring beam BT12 that is to transmit the beam splitter 152 and the measuring beam BT11 parallel to the X-axial direction. The bending mirror 153 changes the direction of the measuring beam BT12 that has transmitted the beam splitter 152 towards the -X direction so that the measuring beam BT12 is incident upon the prism 154. The prism 154 reflects the measuring beam BT12 changed the direction by the bending mirror 153 towards a direction orthogonal to the reflecting surface 27b of the fixed mirror 27.

On the other hand, the measuring beam BT11 produced as a result of dividing by the beam splitter 152 is emitted towards the reflecting surface 27a of the fixed mirror 27 and reflected at the reflecting surface 27a towards the beam splitter 152.

The measuring beam BT11 reflected at the reflecting surface 27a and the measuring beam BT12 reflected at the reflecting surface 27b travel along the original optical paths thereof and are received by the light receiving part 57a of the Z-axis interferometer 22 via the bending mirror 33.

In the main control apparatus 20, a Z displacement of the wafer table WTB is detected using the above-described Formula (1) based on a difference between the optical path lengths of the measuring beams BT11 and BT12 received by the light receiving part 57a of the Z-axis interferometer 22. In this case, the Z displacement obtained based on the above-described Formula (1), that is, the Z displacement detected using the optical element group OP 1 represents a Z displacement as detected at a measurement point VP 1 where the measuring beam BT11 intersects the measuring beam BT12 (refer to FIG. 20 for planar layout).

Similarly, as shown in FIG. 20, the optical element group OP2 is provided on the +Y side surface of the wafer stage main body 28, on the optical path of the measuring beam BT2, and adjacent to the -X side of the wafer stage main body 28. As shown in FIG. 21, the optical element group OP2 includes a beam splitter (first optical member, optical separation member) 161 optically coupled with the bending mirror 33, a bending mirror 162, and a prism (second optical part) 163.

The beam splitter 161 divides the incident measuring beam BT2 into the measuring beam BT21 that is to transmit the beam splitter 161 and to be emitted towards the reflecting surface 27a of the fixed mirror 27 and the measuring beam BT22 that is directed towards the -Z direction. The bending mirror 162 changes the direction of the measuring beam BT22 emitted from the beam splitter 161 towards the -X direction so that the measuring beam BT22 is incident upon the prism 163. The prism 163 reflects the measuring beam BT22 changed the direction by the bending mirror 162 towards a direction orthogonal to the reflecting surface 27b of the fixed mirror 27.

The measuring beam BT21 reflected at the reflecting surface 27a and the measuring beam BT22 reflected at the reflecting surface 27b travel along the original optical paths thereof and are received by the light receiving part 57b of the Z-axis interferometer 22 via the bending mirror 33.

In the main control apparatus 20, a Z displacement of the wafer table WTB is detected using the above-described Formula (1) based on a difference between the optical path lengths of the measuring beams BT21 and BT22 received by the light receiving part 57b of the Z-axis interferometer 22. In this case, the Z displacement obtained based on the above-described Formula (1), that is, the Z displacement detected using the optical element group OP2 represents a Z displacement as detected at a measurement point VP2 where the measuring beam BT21 intersects the measuring beam BT22 (refer to FIG. 20 for planar layout).

Similarly, as shown in FIG. 20, the optical element group OP3 is provided on the- Y side surface of the wafer stage main body 28, on the optical path of the measuring beam BT3, and adjacent to the -X side of the wafer stage main body 28. As shown in FIG. 22, the optical element group OP3 includes a bending mirror (first optical member) 171 optically coupled with the bending mirror 32, a bending mirror 172, a beam splitter (optical separation member) 173, a bending mirror 174, and a prism (second optical part) 175.

Although not shown in the figure, optical element groups for changing the angles of measuring beams are provided on the incident sides of the prisms 154, 163, and 175 in the optical element groups OP 1 to OP3.

The bending mirror 171 changes the direction of the incident measuring beam BT3 towards the -Z direction, and the bending mirror 172 changes, towards the -X direction, the direction of the measuring beam BT3 changed the direction by the bending mirror 171 so that the measuring beam BT3 is incident upon the beam splitter 173. The beam splitter 173 divides the measuring beam BT3 changed the direction by the bending mirror 172 into the measuring beam BT31 that transmits the beam splitter 173 and proceeds towards the reflecting surface 27a of the fixed mirror 27 and the measuring beam BT32 directed towards the +Z side. The bending mirror 174 changes the direction of towards the -X direction the measuring beam BT32 changed the direction towards the +Z side by the beam splitter 173 so that the measuring beam BT32 is incident upon the prism 175. The prism 175 reflects the measuring beam BT32 changed the direction by the bending mirror 174 towards a direction orthogonal to the reflecting surface 27b of the fixed mirror 27.

The measuring beam BT31 reflected at the reflecting surface 27a and the measuring beam BT32 reflected at the reflecting surface 27b travel along the original optical paths thereof and are received by the light receiving part 57c of the Z-axis interferometer 22 via the bending mirror 32.

In the main control apparatus 20, a Z displacement of the wafer table WTB is detected using the above-described Formula (1) based on a difference between the optical path lengths of the measuring beams BT31 and BT32 received by the light receiving part 57c of the Z-axis interferometer 22. In this case, the Z displacement obtained based on the above-described Formula (1), that is, the Z displacement detected using the optical element group OP3 represents a Z displacement as detected at a measurement point VP3 where the measuring beam BT31 intersects the measuring beam BT32 (refer to FIG 20 for planar layout).

In this optical element group OP3, the position of each optical element is set so that the measurement point VP3 is located to the incident side (+X side) of the measuring beam BT3 from the optical element group OP3 (bending mirror 171).

The main control apparatus 20 obtains the amount of rolling θy of the wafer table WTB based on the positions of the measurement points VP1 and VP2 and the Z displacements measured at these positions as in the case of the above-described measurement points VP34 to VP36. The main control apparatus 20 further obtains the amount of pitching θx of the wafer table WTB based on the position of the measurement point VP3 and the Z displacement measured at that position, to adjust the Z position and the orientation of the wafer table WTB.

The Z displacement, at a position of the wafer stage WST, produced via conversion or calculation based on, for example, the above-described Formula (4) may involve an error because the Z displacements obtained at the measurement points VP34 to VP36 shown in FIG. 14 of the above-described first embodiment represent values at measurement points apart from the wafer stage WST whose Z position and orientation are to be adjusted. According to this embodiment, however, the measurement points VP1 to VP3 are set at positions surrounding part of the wafer stage WST, as shown in FIG 20, and therefore, conversion or calculation for a Z displacement at a position of the wafer stage WST is not required. This can increase the measurement accuracy of the Z position and the orientation of the wafer stage WST.

Therefore, in this embodiment, not only are the same advantages as those in the above-described first embodiment provided, but also the position and orientation of the wafer stage WST can be controlled with high accuracy, and consequently, pattern transfer to the wafer W can be performed with higher accuracy.

In particular, according to this embodiment, surrounding part of the wafer stage WST by the measurement points VP1 to VP3 is easily embodied by setting the measurement point VP3 to the incident side (+X side) of the measuring beam BT3 from the optical element group OP3 (bending mirror 171). This contributes to enhance the accuracy with which the Z position and the orientation of the wafer stage WST are measured.

The structure of the optical elements of the optical element groups OP1 to OP3 in this embodiment represents just one example. Another structure may also be employed as long as the measurement points VP1 to VP3 corresponding to the optical element groups OP1 to OP3, respectively, surround at least part of the wafer stage WST.

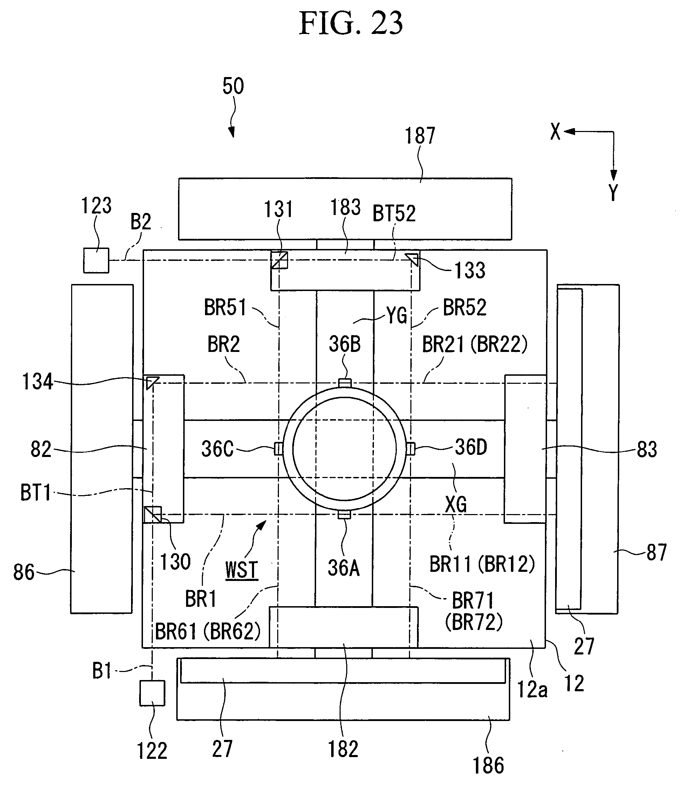

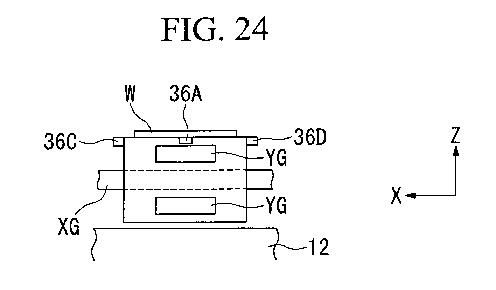

FIGs. 23 and 24 are diagrams showing a third embodiment of a stage apparatus according to the present invention.

In these figures, the same components as those referred to in the first embodiment shown in FIGs. 1 to 19 are denoted by the same symbols, and a description thereof will be omitted.

In the stage apparatus 50 of this embodiment, the wafer stage WST is formed in a circle in plan view. This wafer stage WST is movably supported on a Y guide bar YG extending in the Y-axial direction via an air bearing (not shown in the figure) and is also movably supported on an X guide bar XG extending in the X-axial direction via an air bearing (not shown in the figure). As shown in FIG. 24, the X guide bar XG is disposed through the wafer stage WST at a height corresponding to the center of gravity at the central position in the Z direction of the wafer stage WST. On the other hand, the Y guide bar YG is provided so as to sandwich the X guide bar XG in the vertical direction.

The movers 82 and 83 are provided at both ends of the X guide bar XG These movers 82 and 83 and the stators 86 and 87 extending in the Y-axial direction constitute a moving coil type Y-axis linear motor for driving the wafer stage WST in the Y-axial direction. Similarly, movers 182 and 183 are provided at both ends of the Y guide bar YG These movers 182 and 183 and the stators 186 and 187 extending in the X-axial direction constitute a moving coil type X-axis linear motor for driving the wafer stage WST in the X-axial direction. The wafer stage WST can be moved in the θZ-axial direction by synchronously varying the amounts of driving of the movers 82 and 83 and the movers 182 and 183.

On this stage apparatus 50, an interferometer 122 for emitting the detecting beam B1 along the Y-axial direction and an interferometer 123 for emitting the detecting beam B2 along an X-axial direction are provided. On the optical path of the detecting beam B1, a half mirror 130 that transmits the detecting beam B1 as the transmission beam BT 1 and reflects the detecting beam B1 as the reflected beam BR1 along the X-axial direction; and a bending mirror 134 that changes the direction of the transmission beam BT 1 (reflects the transmission beam BT1) that has transmitted the half mirror 130 as the reflected beam BR2 along the X-axial direction are mounted on the mover 82.

On the optical path of the reflected beam BR1, a prism 36A with the same structure as that of the prism 36 described in the first embodiment is provided at a +Y side end portion of the wafer stage WST. Above the stator 87, the fixed mirror 27 having the reflecting surfaces 27a and 27b (not shown in FIG. 23, but refer to, for example, FIG. 6) is provided along the Y-axial direction. Then, the measuring beams BR11 and BR12 emitted from the prism 36A are reflected at the reflecting surfaces 27a and 27b of the fixed mirror 27 and received by the interferometer 122 via the prism 36A and the half mirror 130.

Similarly, on the optical path of the reflected beam BR2, a prism 36B with the same structure as that of the prism 36A is provided at a -Y side end portion of the wafer stage WST. Then, the measuring beams BR21 and BR22 emitted from the prism 36B are reflected at the reflecting surfaces 27a and 27b of the fixed mirror 27 and received by the interferometer 122 via the prism 36B, the bending mirror 134, and the half mirror 130.

On the optical path of the detecting beam B2, a half mirror 131 that transmits the detecting beam B2 as a transmission beam BT52 and reflects the detecting beam B2 as a reflected beam BR51 along the Y-axial direction; and a bending mirror 133 that changes the direction of the transmission beam BT52 (reflects the transmission beam BT52) that has transmitted the half mirror 131 as a reflected beam BR52 along the Y-axial direction are mounted on the mover 183.

On the optical path of the reflected beam BR51, a prism 36C with the same structure as that of the prism 36A is provided at a +X side end portion of the wafer stage WST. Above the stator 186, the fixed mirror 27 having the reflecting surfaces 27a and 27b (not shown in FIG 23, but refer to, for example, FIG. 6) is provided along the X-axial direction. Then, measuring beams BR61 and BR62 emitted from the prism 36C are reflected at the reflecting surfaces 27a and 27b of the fixed mirror 27 and received by the interferometer 123 via the prism 36C and the half mirror 131.

Similarly, on the optical path of the reflected beam BR52, a prism 36D with the same structure as that of the prism 36C is provided at a -X side end portion of the wafer stage WST. Then, measuring beams BR71 and BR72 emitted from the prism 36D are reflected at the reflecting surfaces 27a and 27b of the fixed mirror 27 and received by the interferometer 123 via the prism 36D, the bending mirror 133, and the half mirror 131.

With the above-described structure, the Z position, the amount of pitching, and the amount of rolling of the wafer stage WST can be detect in the same manner as with the above-described first embodiment by receiving the measuring beams BR11, BR12, BR21, and BR22 via the prisms 36A and 36B and receiving the measuring beams BR61, BR62, BR71, and BR72 via the prisms 36C and 36D. Furthermore, in this embodiment, unlike the first embodiment, a detecting beam (not shown in the figure) for another axis is emitted from each of the interferometers 122 and 123. By doing, the interferometer 122 can detect the position in the X-axial direction and the position in the θZ direction of the wafer stage WST by receiving the reflection of this detecting beam from the reflecting surface 27a. Furthermore, the interferometer 123 can detect the position in the Y-axial direction and the position in the θZ direction of the wafer stage WST by receiving the reflection of this detecting beam from the reflecting surface 27a.

Therefore, in this embodiment, not only are the same advantages as those in the above-described first embodiment provided, but also it is not necessary to provide the wafer stage WST with a movable mirror for reflecting a detecting beam from an interferometer. As a result, the size and weight of the wafer stage WST can be reduced so as to match the shape of the wafer stage WST substantially to the external shape of the wafer W.

Furthermore, in this embodiment, since the linear motors for moving the wafer stage WST are located apart from the wafer stage WST, heat generated by motor driving is also apart from the wafer stage WST, and therefore, averse affects by heat on the wafer stage WST can be minimized.

Although, in the above-described first embodiment, the Z positions of the wafer stage WST and the measurement stage MST are detected using the Z-axis interferometer 22, the present invention is not limited thereto. The position only in the X-axial direction may be detected instead.

Furthermore, although the stage apparatus 50 includes both the wafer stage WST and measurement stage MST in the above-described first embodiment, the stage apparatus 50 may include only the wafer stage WST as in the second embodiment.

In addition, the present invention can also be adapted to a twin stage type exposure apparatus, wherein a plurality of wafer stages is provided. The structure and exposure operation of a twin stage type exposure apparatus is disclosed in, for example, Japanese Unexamined Patent Application, First Publication No. H10-163099, Japanese Unexamined Patent Application, First Publication No. H10-214783 (corresponding U.S. Patent Nos. 6,341,007, 6,400,441, 6,549,269 and 6,590,634), Published Japanese Translation No. 2000-505958 of the PCT International Publication (corresponding U.S. Patent No. 5,969,441), or U.S. Patent No. 6,208,407. Furthermore, the present invention may be adapted to the wafer stage disclosed in Japanese Patent Application No. 2004-168481, which was previously filed by the present applicant.

Furthermore, the above-mentioned embodiment is constituted so that the present invention is adapted to the stage apparatus 50 on the wafer W side, but can also be adapted to the reticle stage RST on the reticle R side.

Furthermore, the substrate held by the movable stage in each of the above-mentioned embodiments is not limited to a semiconductor wafer for fabricating semiconductor devices, but can also be adapted to, for example, a glass substrate for a display device, a ceramic wafer for a thin film magnetic head, or a mask or the original plate of a reticle (synthetic quartz, silicon wafer) used by an exposure apparatus.

The exposure apparatus 100 can also be adapted to a scanning type exposure apparatus that does not use the liquid immersion method, and to a step-and-repeat type projection exposure apparatus (stepper) that exposes the full pattern of the reticle R with the reticle R and the wafer W in a stationary state, and sequentially steps the wafer W. In addition, the present invention can also be adapted to a step-and-stitch type exposure apparatus that partially and superposingly transfers at least two patterns onto the wafer W.

The types of exposure apparatus 100 are not limited to exposure apparatuses for semiconductor element manufacture that expose a semiconductor element pattern onto the wafer W, but are also widely applicable to exposure apparatuses for the manufacture of liquid crystal display elements and for the manufacture of displays, and exposure apparatuses for the manufacture of thin film magnetic heads, image pickup elements (CCD), and reticles or masks.

If a linear motor is used in the wafer stage WST or the reticle stage RST (refer to U.S. Patent No. 5,623,853 and U.S. Patent No. 5,528, 118), then either an air levitation type that uses an air bearing, or a magnetic levitation type that uses Lorentz's force or reactance force may be used. In addition, each of the stages WST and RST may be a type that moves along a guide or may be a guideless type.

For the drive mechanism of each of the stages WST and RST, a planar motor may be used that opposes a magnet unit, wherein magnets are disposed two dimensionally, to an armature unit, wherein coils are disposed two dimensionally, and drives each of the stages WST and RST by electromagnetic force. In this case, either the magnet unit or the armature unit is connected to the stages WST and RST and the other one should be provided on the plane of motion side of the stages WST and RST.

The reaction force generated by the movement of the wafer stage WST may be mechanically discharged to the floor (ground) by using a frame member so that it is not transmitted to the projection optical system PL, as recited in Japanese Unexamined Patent Application, First Publication No. H08-166475 (corresponding U.S. Patent No. 5,528,118).

The reaction force generated by the movement of the reticle stage RST may be mechanically discharged to the floor (ground) by using a frame member so that it is not transmitted to the projection optical system PL, as recited in Japanese Unexamined Patent Application, First Publication No. H8-330224 (corresponding U.S. Patent Application S/N 08/416,558).

As described above, the exposure apparatus 100 of the embodiments of this application is manufactured by assembling various subsystems, including the respective constituent elements presented in the Scope of Patents Claims of the present application, so that the prescribed mechanical precision, electrical precision and optical precision can be maintained. To ensure these respective precisions, the above-described assembly is preceded and followed by adjustments for achieving optical precision with respect to the various optical systems, adjustments for achieving mechanical precision with respect to the various mechanical systems, and adjustments for achieving electrical precision with respect to the various electrical systems. The process of assembly from the various subsystems to the exposure apparatus includes mechanical connections, electrical circuit wiring connections, air pressure circuit piping connections, etc. among the various subsystems. Obviously, before the process of assembly from these various subsystems to the exposure apparatus, there are the processes of individual assembly of the respective subsystems. When the process of assembly to the exposure apparatuses of the various subsystems has ended, overall assembly is performed, and the various precisions are ensured for the exposure apparatus as a whole. Furthermore, it is preferable to manufacture the exposure apparatus in a clean room wherein, for example, the temperature and the cleanliness level are controlled.

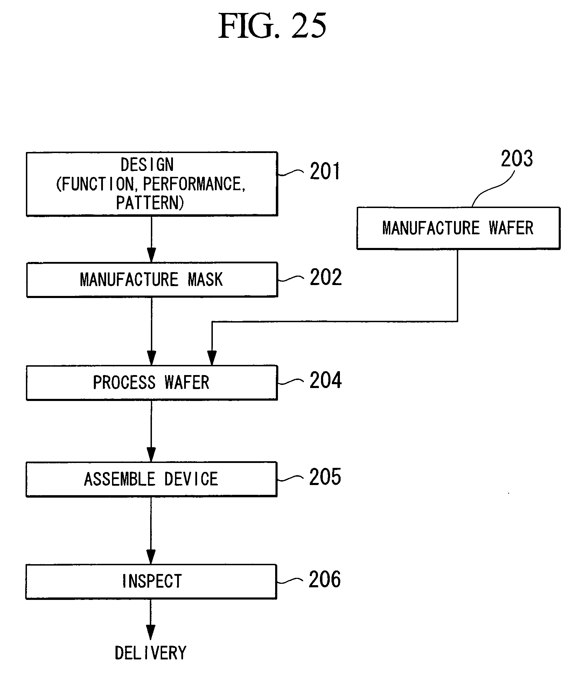

As shown in FIG. 25, microdevices such as semiconductor devices are manufactured by going through; a step 201 that performs microdevice function and performance design, a step 202 that creates the mask (reticle) based on this design step, a step 203 that manufactures the wafer (substrate) that is the device base material, a wafer processing step 204 that exposes the mask pattern onto a wafer (substrate) using the exposure apparatus 100 of the aforementioned embodiments, a device assembly step (including a dicing process, a bonding process and a packaging process) 205, and an inspection step 206, and so on.

### Claims

1. A stage apparatus comprising:

   a movable stage that moves along a plane of motion; and
   a position-detection apparatus that detects a position of the movable stage with a beam,
   the stage apparatus further comprising:

   a driving apparatus that drives the movable stage;
   a follow-up optical member that is provided at the driving apparatus and causes the beam to follow the movable stage as the movable stage moves; and
   a first optical member that is provided on the movable stage and is optically coupled with the follow-up optical member.

2. The stage apparatus according to Claim 1, wherein the position-detection apparatus comprises a correction apparatus that corrects an optical error in the follow-up optical member resulting from the driving apparatus.

3. The stage apparatus according to Claim 1 or 2, further comprising a temperature regulator that adjusts a temperature of a space in which at least the follow-up optical member performs follow-up movement.

4. A stage apparatus comprising:

a movable stage that moves along a plane of motion; and
a position-detection apparatus that detects a position of the movable stage,
the stage apparatus further comprising:

> a first optical member that is provided on the movable stage;
> a second optical member that changes the direction of a beam from a light source towards the first optical member; and
> a follow-up apparatus that causes the second optical member to follow a movement of the movable stage.

5. The stage apparatus according to Claim 4, wherein
the movable stage can move in a first direction and a second direction along the plane of motion,
the second optical member changes the direction of the beam towards the first direction, and
the follow-up apparatus drives the second optical member along the second direction.

6. The stage apparatus according to Claim 4 or 5, further comprising a temperature regulator that adjusts a temperature of a space in which at least the second optical member performs follow-up movement.

7. A stage apparatus comprising:

> a movable stage that moves along a plane of motion; and
> a position-detection apparatus that detects a position of the movable stage,
> the stage apparatus further comprising:

> > a first optical member that is provided on the movable stage and changes the direction of an incident beam towards a direction intersecting the plane of motion; and
> > a second optical member that is provided on the movable stage and changes the direction of the beam from the first optical member towards a direction intersecting the plane of motion.

8. The stage apparatus according to Claim 7, wherein an angle by which the beam is changed the direction by the first optical member differs from an angle by which the beam is changed the direction by the second optical member.

9. The stage apparatus according to one of Claims 1 to 8, wherein a plurality of the first optical members is provided on the stage.

10. The stage apparatus according to Claim 9, wherein
the position-detection apparatus has a plurality of measurement points set at positions apart from the first optical members according to the respective positions of the plurality of first optical members, and
at least one of the plurality of measurement points is set to an incident side of the beam from the first optical members.

11. The stage apparatus according to Claim 10, wherein the plurality of measurement points is set at positions surrounding at least part of the movable stage.

12. The stage apparatus according to one of Claims 9 to 11, wherein the position-detection apparatus detects an amount of tilting of the movable stage.

13. A stage apparatus comprising:

> a movable stage that moves along a plane of motion; and
> a position-detection apparatus that detects a position of the movable stage with a beam,
> the stage apparatus further comprising:

> > optical separation members that are provided on the movable stage, each of the optical dividing members divides the beam into a first measuring beam along the plane of motion and a second measuring beam intersecting the plane of motion; and
> > a reflecting member that has a first reflecting surface and a second reflecting surface, the first reflecting surface reflecting the first measuring beam towards the optical separation members, the second reflecting surface reflecting the second measuring beam towards the optical separation members.

**14.** The stage apparatus according to Claim 13, wherein
the optical separation members are provided at three locations of the movable stage, and
the position-detection apparatus detects an amount of tilting of the movable stage and a position of the movable stage in a direction orthogonal to the plane of motion.

**15.** A stage apparatus comprising:

a first movable stage that moves along a plane of motion;
a second movable stage that moves along the plane of motion; and
a position-detection apparatus that detects positions of the first movable stage and the second movable stage with a beam,
the stage apparatus further comprising:

an optical separation system that divides the beam into a first beam and a second beam such that height positions in a direction orthogonal to the plane of motion are the same;

a first optical system that is provided at the first movable stage, changes the height position of the first beam having been incident, and emits the first beam; and
a second optical system that is provided at the second movable stage, changes the height position of the second beam having been incident, and emits the second beam.

**16.** The stage apparatus according to Claim 15, wherein the height position of the first beam emitted from the first optical system differs from the height position of the second beam emitted from the second optical system.

**17.** A stage apparatus comprising:

a first movable stage that moves along a plane of motion;
a second movable stage that moves along the plane of motion; and
a position-detection apparatus that detects positions of the first movable stage and the second movable stage,
the stage apparatus further comprising:

a first optical system that is provided on the first movable stage;
a second optical system that is provided on the second movable stage; and
a reflecting member that reflects a first beam from the first optical system and a second beam from the second optical system.

**18.** The stage apparatus according to Claim 17, wherein the reflecting member comprises a first reflecting surface having an angle causing the first reflecting surface to intersect the plane of motion and a second reflecting surface having an angle causing the second reflecting surface to intersect the first reflecting surface.

**19.** The stage apparatus according to Claim 18, wherein the first reflecting surface and the second reflecting surface are integrally formed.

**20.** The stage apparatus according to one of Claims 15 to 19, wherein
a plurality of the first optical systems and a plurality of the second optical systems are provided, and
the position-detection apparatus detects an amount of tilting of the first movable stage and an amount of tilting of the second stage.

**21.** The stage apparatus according to one of Claims 1 to 20, wherein the position-detection apparatus comprises an interferometer.

**22.** An exposure apparatus for exposing a pattern onto a substrate using a stage apparatus, wherein the stage apparatus is a stage apparatus according to one of Claims 1 to 21.

**23.** An exposure apparatus for exposing a pattern onto a substrate via liquid supplied to the substrate, the exposure apparatus comprising:

a first substrate table that has a support surface, the support surface supporting the substrate;

a first stage main body that is provided below the first substrate table and has at least one side surface positioned towards an inner side from a side surface of the first substrate table;

a first optical member that is provided on the at least one side surface of the first stage main body and that upon which a beam is incident and from which the beam is emitted in a direction intersecting the support surface; and

a first position-detection apparatus that detects a position of the substrate in the direction intersecting the support surface in conjunction with the first optical member.

24. The exposure apparatus according to Claim 23, further comprising a first driving apparatus that drives the first stage main body and has a first mover and a first stator, the first mover provided on the first stage main body, the first stator operating in conjunction with the first mover.

25. The exposure apparatus according to Claim 24, wherein the stage main body has an aperture and the mover is provided in the aperture.

26. The exposure apparatus according to Claim 23, further comprising:

a second substrate table that has a support surface;

a second stage main body that is provided below the second substrate table and has at least one side surface positioned towards an inner side from a side surface of the second substrate table;

a second optical member that is provided on the at least one side surface of the second stage main body and that upon which a beam is incident and from which the beam is emitted in a direction intersecting the support surface; and

a second position-detection apparatus that detects a position in the direction intersecting the support surface in conjunction with the second optical member.

27. The exposure apparatus according to Claim 26, further comprising a second driving apparatus that drives the second stage main body and has a second mover and a second stator, the second mover provided on the second stage main body, the second stator operating in conjunction with the second mover.

28. The exposure apparatus according to Claim 27, further comprising a control apparatus that controls the first driving apparatus and the second driving apparatus to cause the first stage main body and the second stage main body to be close to each other.

29. The exposure apparatus according to Claim 28, wherein the control apparatus causes the first stage main body and the second stage main body to be close to each other after exposure of the pattern onto the substrate ends.

# FIG. 1

# FIG. 2

EP 1 791 165 A1

# FIG. 3

# FIG. 4

# FIG. 5

EP 1 791 165 A1

# FIG. 6

EP 1 791 165 A1

# FIG. 7

32  33  BT1  BT3  WTB (WST)  VP34  BT32  27b  27

35  34  34A  BT32  VP35  BT11 (BT31)  27a

BT3  BT12  BT32  BT12  12a

35A  28  12

Z

X

EP 1 791 165 A1

# FIG. 8

# FIG. 9

EP 1 791 165 A1

FIG. 10

# FIG. 11

EP 1 791 165 A1

FIG. 12

EP 1 791 165 A1

# FIG. 13

RETICLE INTERFEROMETER — 116

INTERFEROMETER SYSTEM — 118

ALIGNMENT SYSTEM — ALG

RETICLE ALIGNMENT DETECTION SYSTEMS — RAa, RAb

IRRADIATION SYSTEM — 90a

LIGHT RECEIVING SYSTEM — 90b

MEASURING INSTRUMENT GROUP — 43

MEMORY — MEM

MAIN CONTROL APPARATUS — 20

RETICLE STAGE DRIVE PART — 11

STAGE DRIVE PART — 124

IMAGING-CHARACTERISTIC CORRECTION CONTROLLER — 381

LIQUID SUPPLY APPARATUS — 288

LIQUID RECOVERY APPARATUS — 292

DISPLAY — DIS

# FIG. 14

## FIG. 15A

VP36    VP35

VPn

Dx    Lx

## FIG. 15B

$\frac{1}{2}$(VP35+VP36)    VPn    VP34

Dy

Ly

## FIG. 16

VP38

39    38    LMx    VP39

VP37

LMy

37    VP37

# FIG. 17A

# FIG. 17B

# FIG. 18A

# FIG. 18B

EP 1 791 165 A1

FIG. 19

47

# FIG. 20

FIG. 21

# FIG. 22

EP 1 791 165 A1

# FIG. 23

# FIG. 24

# FIG. 25

```
┌──────────────────────────┐
│         DESIGN           │╮ 201                    203
│  (FUNCTION, PERFORMANCE, │╯                    ╭────────────────────────────┐
│         PATTERN)         │              ┌──────┤   MANUFACTURE  WAFER       │
└──────────────────────────┘              │      └────────────────────────────┘
             │                            │
             ▼                            │
┌──────────────────────────┐              │
│    MANUFACTURE  MASK      │╮ 202         │
└──────────────────────────┘╯             │
             │              │             │
             ▼              ▼             │
┌──────────────────────────┐
│      PROCESS  WAFER       │╮ 204
└──────────────────────────┘╯
             │
             ▼
┌──────────────────────────┐
│     ASSEMBLE  DEVICE      │╮ 205
└──────────────────────────┘╯
             │
             ▼
┌──────────────────────────┐
│        INSPECT           │╮ 206
└──────────────────────────┘╯
             │
             ▼
          DELIVERY
```

## INTERNATIONAL SEARCH REPORT

| International application No. |
| --- |
| PCT/JP2005/014115 |

A. CLASSIFICATION OF SUBJECT MATTER
*H01L21/027* (2006.01), *G01B11/00* (2006.01), *G03F7/20* (2006.01), *H01L21/68* (2006.01)

According to International Patent Classification (IPC) or to both national classification and IPC

B. FIELDS SEARCHED

Minimum documentation searched (classification system followed by classification symbols)
*H01L21/027* (2006.01), *G01B11/00* (2006.01), *G03F7/20* (2006.01), *H01L21/68* (2006.01)

Documentation searched other than minimum documentation to the extent that such documents are included in the fields searched

| | | | |
| --- | --- | --- | --- |
| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X | JP 2002-319541 A (Canon Inc.), 31 October, 2002 (31.10.02), | 1,4,9,12,21, 22 |
| A | Full text; all drawings & US 2002/109850 A1 & US 6819433 B2 | 2,5 |
| X | JP 2003-254739 A (Canon Inc.), 10 September, 2003 (10.09.03), | 1,4,9,21,22 |
| A | Mode 2; Fig. 9 & US 2003/165265 A1 | 2,5 |
| X | JP 05-217837 A (Toshiba Corp.), 27 August, 1993 (27.08.93), | 1,4,5,9,21, 22 |
| A | Full text; all drawings (Family: none) | 2,21 |

| ☒ Further documents are listed in the continuation of Box C. | ☐ See patent family annex. |
| --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 28 October, 2005 (28.10.05) | 08 November, 2005 (08.11.05) |

| Name and mailing address of the ISA/ | Authorized officer |
| --- | --- |
| Japanese Patent Office | |
| Facsimile No. | Telephone No. |

Form PCT/ISA/210 (second sheet) (April 2005)

EP 1 791 165 A1

**INTERNATIONAL SEARCH REPORT**

International application No.

PCT/JP2005/014115

C (Continuation).   DOCUMENTS CONSIDERED TO BE RELEVANT

| Category* | Citation of document, with indication, where appropriate, of the relevant passages | Relevant to claim No. |
|---|---|---|
| X | JP 2001-307983 A  (Nikon Corp.),<br>02 November, 2001 (02.11.01), | 1,4,5,9,21,<br>22 |
| A | Full text; all drawings; particularly,<br>Par. Nos. [0024] to [0028]; Fig. 3<br>(Family: none) | 2,12 |
| X | JP 08-022948 A  (Nikon Corp.),<br>23 January, 1996 (23.01.96), | 1,4,9,21,22 |
| A | Full text; all drawings; particularly,<br>Par. Nos. [0040] to [0042]; Fig. 8<br>(Family: none) | 2,5,12 |

Form PCT/ISA/210 (continuation of second sheet) (April 2005)

## INTERNATIONAL SEARCH REPORT

| International application No. |
| --- |
| PCT/JP2005/014115 |

**Box No. II    Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III    Observations where unity of invention is lacking (Continuation of item 3 of first sheet)**

This International Searching Authority found multiple inventions in this international application, as follows:

The inventions in the following claims have the same technical feature in that claim 2 relates to the correction of an optical error of a tracking optical member caused by a drive device, claims 3,6 relate to temperature regulation of a space a tracking optical member follows up, claims 7,8 relate to a first optical member for bending an incident beam into a direction crossing a stage moving surface and a second optical member for bending a beam from the first optical member into a direction crossing the above moving surface, claims 10,11 relate to setting one of a plurality of measuring points to a beam incident side with respect to an optical member provided on a stage, claims 13,14 relate to a branching optical member for branching into   (continued to extra sheet)

1. ☐ As all required additional search fees were timely paid by the applicant, this international search report covers all searchable claims.

2. ☐ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☒ No required additional search fees were timely paid by the applicant.   Consequently, this international search report is restricted to the invention first mentioned in the claims; it is covered by claims Nos.:1,2,4,5,9,12,21,22

**Remark on Protest**        ☐ The additional search fees were accompanied by the applicant's protest and, where applicable, the payment of a protest fee..

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (April 2005)

**INTERNATIONAL SEARCH REPORT**

International application No.

PCT/JP2005/014115

Continuation of Box No.III of continuation of first sheet(2)

a beam along a stage moving surface and a beam crossing the moving surface, claims 15,16,20 relate to a branching optical system for branching a beam to respective stages and first and second optical systems for changing a beam height position, claims 17-19 relate to a reflection member for respectively reflecting beams from respective stages, claims 23-29 relate to an optical member provided on the side surface of a stage having a side surface on the inner side of a substrate table side surface in an immersion exposure system.

Form PCT/ISA/210 (extra sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004229005 A
- JP 2005120187 A
- JP 2001510577 A
- JP H7176468 A
- US 5646413 A
- JP 2004215439 A
- JP H521314 A
- US 5243195 A
- JP 2002014005 A
- US 20020041377 A
- JP 57117238 A
- US 4465368 A
- JP H1116816 A
- US 20020061469 A
- WO 9960361 A
- EP 1079223 A
- JP H6283403 A

- US 5448332 A
- JP H10163099 A
- JP H10214783 A
- US 6341007 B
- US 6400441 B
- US 6549269 B
- US 6590634 B
- JP 2000505958 A
- US 5969441 A
- US 6208407 B
- JP 2004168481 A
- US 5623853 A
- US 5528118 A
- JP H08166475 A
- JP H8330224 A
- US 416558 A